# EUROPÄISCHE PATENTSCHRIFT

(11) **EP 1 430 603 B1**
(45) Veröffentlichungstag und Bekanntmachung des Hinweises auf die Patenterteilung: **08.06.2011**
(21) Anmeldenummer: 02777176.5
(22) Anmeldetag: 21.09.2002
(51) Int. Cl.: H03K 17/94

(54) **SCHALTUNG MIT EINER OPTOELEKTRISCHEN ANZEIGEEINHEIT**
CIRCUIT WITH AN OPTO-ELECTRONIC DISPLAY UNIT
CIRCUIT POURVU D'UNE UNITE D'INDICATION OPTOELECTRONIQUE

(30) Priorität: 25.09.2001 DE 10146996
(43) Veröffentlichungstag der Anmeldung: 23.06.2004
(73) Patentinhaber: Reime, Gerd, 75328 Schömberg (DE)
(72) Erfinder: Reime, Gerd, 75328 Schömberg (DE)
(74) Vertreter: Reinhardt, Harry
(86) Internationale Anmeldenummer: PCT/EP2002/010630
(87) Internationale Veröffentlichungsnummer: WO 2003/030363

(56) Entgegenhaltungen:
- EP-A- 0 064 025
- EP-A- 0 809 371
- DE-A- 2 824 399

## Beschreibung

Die Erfindung betrifft eine Schaltung mit einer optoelektronischen Anzeigeeinheit nach dem Oberbegriff des Anspruches 1.

Im Bereich der Bedienelemente sind z.B. aus einer Reihe von LEDs gebildete Anzeigen bekannt, die einen eingestellten Wert anzeigen. Dies kann eine LED-Reihe sein, also nebeneinander angeordnete Leuchtdioden, bei denen ein Element leuchtet und einen aktuellen Wert darstellt. In der Regel sind die in Reihe angeordneten Leuchtelemente entsprechend beschriftet, um eine Zuordnung zu einer Größe wie z.B. eine Anzeige in "dB" für eine Lautstärkeeinstellung zu ermöglichen. Das Umschalten auf einen anderen Wert erfolgt mechanisch z.B. durch Tastschalter. Zur Erhöhung bzw. zum Absenken des Wertes wird in der Regel je ein mechanischer Taster eingesetzt. Eine Änderung des Wertes durch entsprechenden Tastendruck wird durch eine Positionsveränderung in der Anzeige durch die entsprechende LED in der Reihe dargestellt.

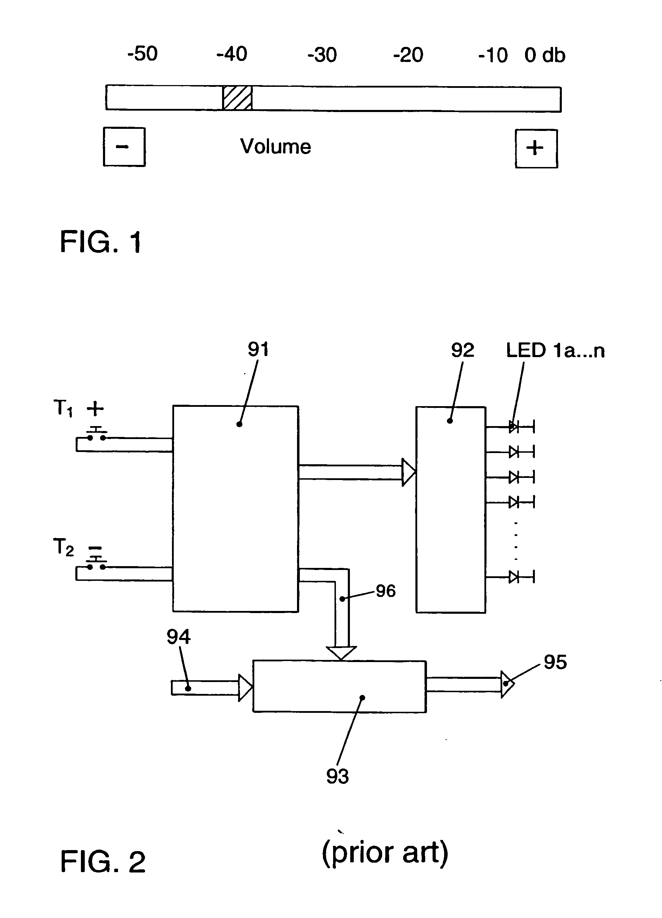

Fig. 1 zeigt eine derartige aus dem Stand der Technik bekannte LED-Anzeige, wobei mit den Plus- bzw. Minus-Tasten die Position der LED und somit auch z.B. der "Lautstärkewert" verstellt werden kann. Der Vorteil einer solchen Anordnung liegt in der klaren Übersicht über die eingestellte Position sowie der spontanen Bedienbarkeit. Nachteilig ist jedoch die Notwendigkeit von mechanischen Durchbrüchen in der Bedienoberfläche und die Anbringung entsprechender Tasten.

Aus der DE 43 36 669 C1 ist ein Tastenfeld mit unterschiedlichen Betätigungsflächen zugeordneten Lichtsensoren bekannt, die auf die Abschattung eines der Größe eines Fingers entsprechende Sensoroberfläche reagieren. Die Erfassung des Umgebungslichts stellt also die zu verarbeitende Information dar. Hierfür wird üblicherweise ein anderes Mittel als das zur Erzeugung eines Lichtsignals verwendete Mittel eingesetzt. Um einen anzuzeigenden Wert darzustellen, wird eine zusätzliche Leuchtanzeigeeinheit benötigt. Die Lichtempfänger und Lichtsender können ausschließlich gepulst bedient werden, was für die diskrete Änderung eines einzustellenden Werts von Nachteil ist (vgl. auch DE 40 07 971 A1 im Infrarotbereich).

Die Erfassung der Information, die zur Veränderung eines einzustellenden Wertes auf einem Bedienfeld notwendig ist, kann auch über Kontaktschalteinrichtungen gemäß DE 694 19 735 T2 oder DE 36 85 749 T2 erfolgen, welche durch die Erfassung einer Kapazität mit dem anzusprechenden Lichtanzeigeelement korrespondieren; diese Anwendung ist jedoch durch ihre Feuchtigkeitsempfindlichkeit auf bestimmte Bereiche begrenzt.

Die DE 39 32 508 A1 zeigt eine übliche Reflexionslichtschranke ohne diskrete Regelungsmöglichkeit. Sender und Empfangselemente müssen immer getrennt vorhanden sein. Die DE 28 24 399 A1 offenbart einen optischen Schalter mit gesonderten Sendern und Empfängem. In beiden Fällen stellen die damit gebildeten Lichtschranken nur das Mittel zum Einstellen der Anzeige und nicht das Anzeigemittel selbst dar.

Aus der US-A 5,327,160 ist ein Touch Fader als Fernbedienung bekannt, der nur getaktet betrieben werden kann.

Anordnungen von Leuchtdioden, die wechselweise gleichermaßen als Licht emittierendes wie als Licht empfangendes Element verwendet werden können und deren Leuchtsignal unmittelbar den anzuzeigenden Wert wiedergibt; die außerdem der Bewegung eines Fingers oder einem vergleichbaren Objekt folgend bedient werden können, um somit den einzustellenden Wert zu erreichen, die aber gleichermaßen auch getaktet, also spontan bedient werden können, sind aus dem Stand der Technik nicht bekannt.

Ausgehend von diesem Stand der Technik liegt der Erfindung die Aufgabe zugrunde, eine günstige Anzeige- und Bedieneinheit zu schaffen und bei der Bedienung einer solchen Regel/Stelleinheit die Anzeige selbst als Bedienelement zu nutzen, wobei sowohl die diskrete Regelung einzustellender Werte als auch die getaktete Handhabung möglich ist.

Diese Aufgabe wird durch eine Schaltung mit den Merkmalen des Anspruches 1 gelöst.

Der durch die Leuchtdioden gebildeten Anzeigeinheit sind Empfangselemente so zugeordnet, dass keine gesonderten mechanische Tasten erforderlich sind. Bei der Bedienung einer solchen Regel-/Stelleinheit wird damit die Anzeige selbst zum Bedienelement. Tasten sind ebenso wenig erforderlich wie Durchbrüche für solche Tasten. Damit wird zum einen die Fertigung einer solchen Bedieneinheit preiswerter, zum anderen kann die Regel-/Stelleinheit unter einer geschlossenen, schützenden Fläche angeordnet werden, so daß sie - leicht zu reinigen und für Schmutz unempfindlich - eine lange Lebensdauer hat und für viele Anwendungszwecke eingesetzt werden kann.

Vorzugsweise sind die Leuchtdioden nicht nur Anzeigeelement sondern temporär alternierend auch Sende- und Empfangselement, so dass der schaltungstechnische Aufwand weiter reduziert werden kann.

Weitere Vorteile ergeben sich aus den Unteransprüchen.

Im Folgenden wird die Erfindung an Hand der beigefügten Zeichnungen näher erläutert. Es zeigen:
- Fig. 1: eine Regel/Stelleinheit nach dem Stand der Technik,
- Fig. 2: ein Blockschaltbild einer Regel/Stelleinheit nach dem Stand der Technik,
- Fig. 3: Schaltbild zur Ansteuerung einer LED als Anzeige- und Bedienelement,
- Fig. 4: ein zur Bedienung verwendbares reflektierendes Element über einer LED- Reihe,
- Fig. 5: eine Anordnung zur Realisierung einer sensitiven LED-Reihe,
- Fig. 6,7: die erfindungsgemäße Schaltung,
- Fig. 8a - 8e: Signalverläufe beim Antippen einer LED,
- Fig. 9: eine Schaltung zur Ansteuerung einer außenliegenden LED,
- Fig. 10: Phasen und Amplitudenbeziehung des analogen Ausgangssignals S17 des Vergleichers 16,
- Fig. 11: das analoge Ausgangssignal S17 über die Zeit beim Umschalten,
- Fig. 12: eine Schaltung zur Erhöhung der Umschaltsicherheit,
- Fig. 13,14: das analoge Ausgangssignal S17 über die Zeit am Ausgang des Buffers B in Fig. 12 mit und ohne Nullreferenzierung,
- Fig. 15: das vom analogen Ausgangssignal S17 abgeleitete Signal V1 über die Zeit am Fensterkomparator gemäß Fig. 14 mit zugehöriger LED- Ansteuerung,
- Fig. 16: eine Schaltung gemäß Fig. 12 mit einem Hysteresedetektor,
- Fig. 17: eine Signalverlauf des Ausgangssignals S17 unter Einsatz des Hystere- sedetektors,
- Fig. 18a -18c: Anordnungen für den Einsatz als Lautstärkeregler, zur Bearbeitung eines Datenstroms oder als Positionsanzeige,
- Fig. 19: ein mechanischer Schieberegler nach dem Stand der Technik,
- Fig. 20 , 21: erfindungsgemäße bogen- und kreisförmige Regel/Stelleinheiten,
- Fig. 22: eine Regel/Stelleinheit in Form eines virtuellen Drehknopfs,
- Fig. 23: eine Regel/Stelleinheit mit zwei Sendeelementen,
- Fig. 24: ein vollständiges Blockdiagramm.

Im Stand der Technik besteht die Schaltzuordnung für eine Stelleinheit nach Fig. 1 gemäß Fig. 2 aus einem Zählwerk 91 dessen momentaner Zustand durch die Tastenfunktionen T1 (z.B. +Taste) und T2 (z.B. -Taste) bestimmt wird. Das Zählwerk 91 zählt bei jedem Betätigen der Tasten T1 bzw. T2 einen Wertschritt nach oben bzw. unten und gibt diese Infotmation an den Anzeigentreiber 92 weiter, der die dem eingestellten Wert entsprechende LED leuchten lässt. Parallel dazu wird der eingestellte Wert an die Steuervorrichtung bzw. den Wertregler 93 weitergeben. Mit diesem Wertregler 93 wird z.B. ein analoges Audiosignal 94/95 entsprechend dem eingestellten Wert 96 in der Amplitude geregelt. Es wird also immer mindestens ein externes Steuersignal T1 bzw. T2 zur Werteinstellung benötigt. Die LEDs 1a...n zeigen nur den eingestellten Wert an und haben keine weitere Funktion.

In der im Folgenden beschriebenen Erfindung wird auf mittelbare Informationsübertragung unter Zuhilfenahme der Taster T1 bzw. T2 verzichtet, so dass die Information direkt von der LED-Anzeige aufgenommen und umgesetzt wird.

Um dies zu erreichen, wird die Bifunktionalität der Leuchtdioden eingesetzt: Diese können Licht aussenden, wenn sie entsprechend mit einem Strom angesteuert werden oder Spannung bzw. Strom abgeben, wenn sie entsprechend beleuchtet werden. Wird nun z.B. eine übersprecharme Beschaltung gewählt, kann eine Leuchtdiode sequentiell als Sender und als Empfänger betrieben werden. Grundsätzlich ist dieselbe Funktion allerdings auch so zu realisieren, dass parallel zu den Licht ausstrahlenden Leuchtdioden alternative Empfangselemente wie z.B. Photodioden eingesetzt werden. Auch dann ist aufgrund der Baugröße die Anzeige immer noch zugleich das Bedienelement, selbst wenn die Leuchtdioden nicht die obige Doppelfunktion aufweisen.

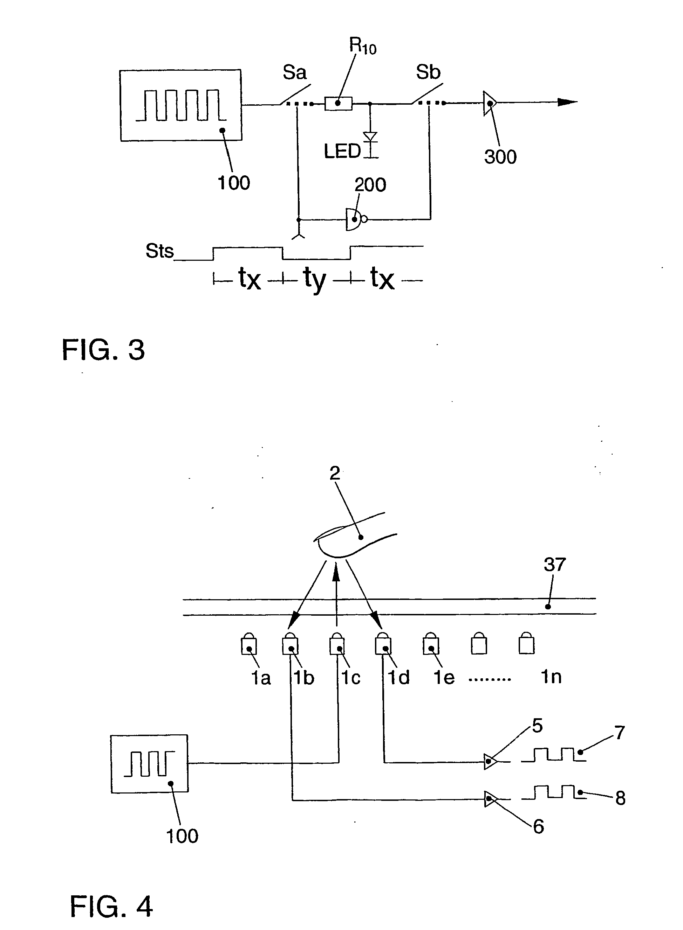

Fig. 3 zeigt eine solche Beschaltung, bei der die Leuchtdioden (LED) zeitsequentiell als Sender und Empfänger arbeiten. In der Phase tₓ ist z.B. der Schalter Sa geschlossen und verbindet den Ausgang des Taktgenerators 100 mit der LED über den Vorwiderstand R₁₀. Der Taktgenerator wird z.B. mit einer Frequenz von 10 kHz betrieben. In dieser Phase ist der Schalter Sb geöffnet und trennt die LED vom Verstärker 300. Der Inverter 200 dient nur zur Invertierung des Steuersignals Sts. In Phase ty kehrt sich das Schalterverhältnis um und der Schalter Sa trennt die LED vom Taktgenerator 100, während Schalter Sb sie mit dem Verstärker 300 verbindet.

Zur Darstellung einer Anzeige wird in der Regel wenigstens ein Element einer LED-Reihe leuchten, während alle anderen ausgeschaltet sind. Selbstverständlich gibt es aber auch Ausbildungen, bei denen alle Anzeigenelemente bis zum eingestellten Wert eingeschaltet sind, also ein Leuchtband bilden. Strahlt das leuchtende Element der LED-Reihe sein Licht nicht durch kontinuierliche Ansteuerung als Gleichlicht ab, sondern wird z.B. mit einem 10 kHz Rechtecksignal gepulst, erscheint es dem menschlichen Auge trotzdem als ein kontinuierlich leuchtendes Element. Gleichzeitig kann es jedoch als Sendeelement einer Sensorvorrichtung eingesetzt werden. Benachbarte LEDs, die entsprechend als Empfänger beschaltet sind, können nämlich das Signal der gepulst angesteuerten LED empfangen, wenn ein reflektierendes Element, z.B. ein Finger 2, sich oberhalb der LED befindet, die das gepulste Licht aussendet.

Bei einer Positionierung des reflektierenden Elements mittig über der sendenden LED 1 c gemäß Fig. 4 wird das ausgesandte Licht gleichmäßig auf die benachbarten LEDs 1b und 1d zurückgestrahlt. Dabei kann sich auch eine für die jeweilige, von der LED ausgesandte Strahlung transluzente Scheibe 37 zwischen den LEDs und dem reflektierenden Element, z.B. einem Finger 2, befinden. Als Strahlung kommen insbesondere alle Lichtstrahlungen im sichtbaren, aber auch im für das menschliche Auge unsichtbaren Bereich in Betracht. Bei symmetrischer Rückstrahlung stellt sich auch an den Ausgängen der Verstärker 5 und 6 eine gleich große Amplitude in den Ausgangssignalen 7,8 ein.

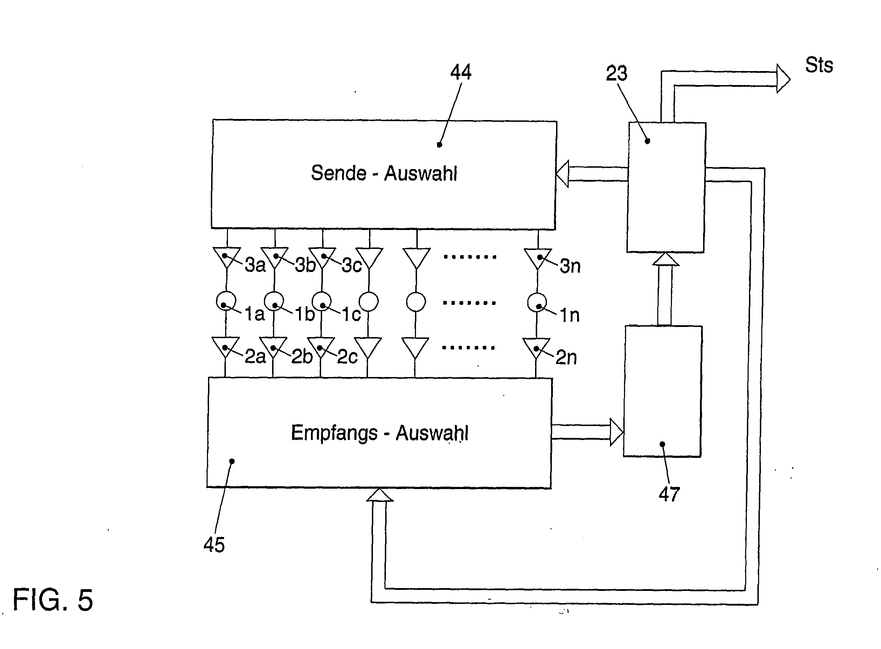

Fig. 5 zeigt eine Anordnung zur Realisierung der sensitiven LED-Reihe. Die Leuchtdioden 1a...1n können sowohl im Sende- wie auch im Empfangsbereich genutzt werden. Für den Sendebetrieb der Leuchtdioden 1a...1n sind zuschaltbare Treiberstufen 3a...3n, für den Empfangsbereich zuschaltbare Verstärker 2a...2n vorgesehen. Die Signalverteilungsstufen 44 und 45 werden durch die Stellung des Positionszählers 23 entsprechend positioniert. Die Richtungs-Entscheidungs-Einheit 47 stellt die Bewegungsrichtung des reflektierenden Elements fest und entscheidet, wann ein bestimmter Wert der Positionsabweichung statt gefunden hat. War dies der Fall, wird Positionszähler 23 entsprechend angesteuert und zählt einen Positionswert nach oben oder unten. Gleichzeitig kann die Richtungs-Entscheidungs-Einheit 47 feststellen, ob das leuchtende Element "angetippt" wurde, um erst dann auf Bewegung z.B. des Fingers 2 zu reagieren, oder ob es sich um ein versehentliches Berühren der sensoraktiven Oberfläche gehandelt hat und somit keine Reaktion der LED-Anzeige erfolgen soll.

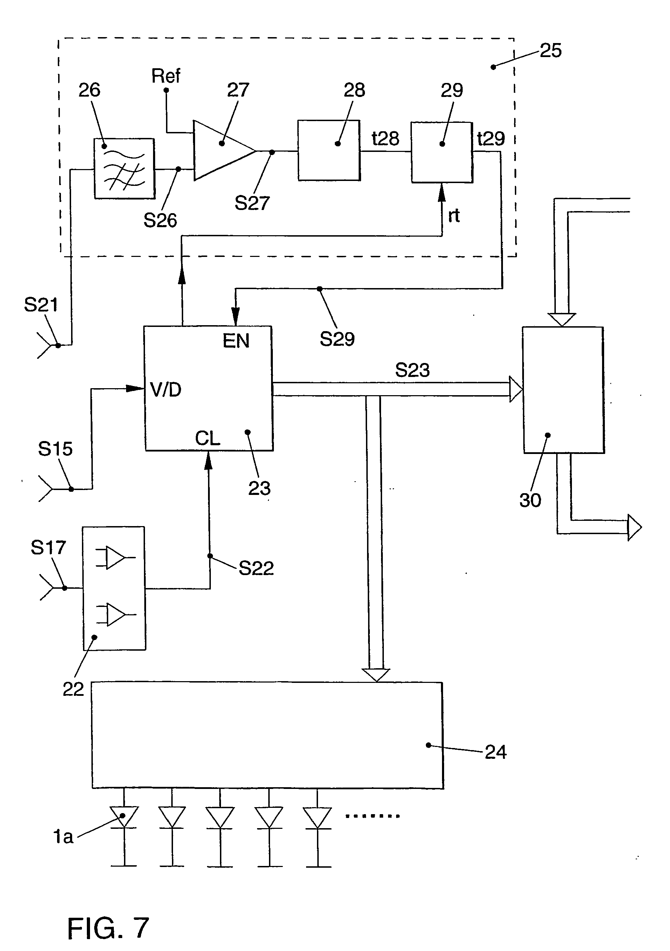

Der Positionszähler 23 steuert über eine Steuereinheit 24 (Fig. 7) sowohl die Ansteuerung der Sendeelemente als auch den Empfangsmodus. Dabei wird jeweils eine einzige LED als Sender angesteuert, während zumindest die ihr benachbarten LEDs - zB. die nächste oder übemächste LED - als Empfänger beschaltet sind. Selbstverständlich können aber auch zwei LEDs gleichzeitig senden und die zwischen den beiden leuchtenden LEDs angeordnete LED als Empfänger beschaltet werden. Grundsätzlich können auch gesonderte Empfangselemente auf Lücke oder versetzt zu den LEDs z.B. in einer zu den LEDs parallelen Reihe angeordnet werden. Am Positionszähler 23 wird ferner das Steuersignal Sts zur Beeinflussung einer beliebigen Regel-/Stelleinheit 30 abgegriffen.

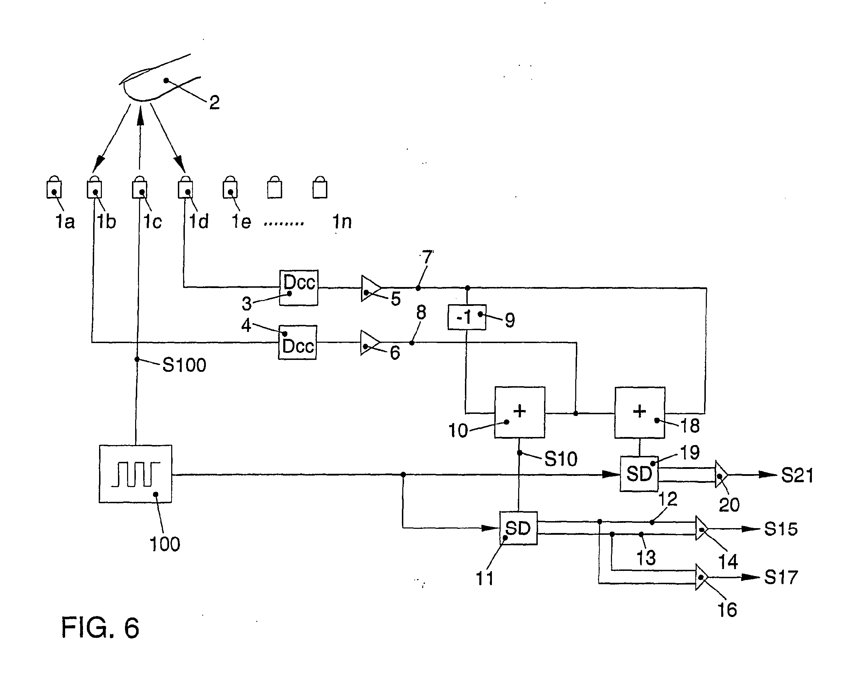

Fig. 6 zeigt eine Schaltung zur Richtungsdetektion, Antipperkennung sowie Erfassung der horizontalen Bewegung des reflektierenden Elements im Verhältnis zur leuchtenden LED, hier LED 1c. LED 1c wird hier vom Taktgenerator 100 angesteuert und sendet Licht aus, das am Finger 2 reflektiert wird. Die benachbarten LEDs 1b, 1d empfangen einen durch den Finger 2 hervorgerufen Reflexionsanteil. DCC 3, 4 bilden eine Arbeitspunkteinstellung für die LEDs als Empfänger. Mit Hilfe dieser DCC (DC-Compensation) wird verhindert, das auch bei starkem Fremdlicht die LEDs in die Sättigung gelangen. Der Aufbau einer derartigen Arbeitspunkteinstellung ist z. B. aus der DE-C 44 31 117 bekannt.

Die Umschalter der LED-Ansteuerung sind der Einfachheit halber nicht eingezeichnet. Zwei gleichartige Verstärker 5 und 6 verstärken die geringen Ausgangssignale der dem Sender benachbarten LEDs 1b und 1d auf einen leicht weiterzuverarbeitenden Wert. Bevor beide Ausgangssignale 7 und 8 in der Additionsstufe 10 zusammengeführt werden, invertiert die Invertierungsschaltung 9 eines der beiden Signale.

Bei Abwesenheit eines reflektierenden Elements, wie eines Fingers 2, oder bei Anwesenheit, jedoch bei symmetrischer Reflexion des Sendesignals zurück in LEDs 1b, 1 d entsteht kein Signal am Ausgang der Additionsstufe 10, bzw. heben sich aufgrund der Invertierungsschaltung 9 zwei etwa vorhandene, aber gleich große Signalanteile auf, so dass wiederum am Ausgang der Additionsstufe 10 kein Signal ansteht. Bei Anwesenheit eines reflektierenden Elements und gleichzeitiger Asymmetrie zur sendenden LED 1 c, z.B. wenn der Finger 2 leicht nach rechts verschoben ist, bildet sich an der LED 1d auf Grund verstärkter Reflexion ein im Verhältnis zur LED 1b größeres Signal aus. Dies führt am Ausgang der Additionsstufe 10 zu einem Signal mit einer taktsynchronen Modulation mit entsprechendem Vorzeichen der Phase im Verhältnis zum Signal des Taktgenerators 100. Die Größe des Signals wird bestimmt von der horizontalen Position des Fingers 2 im Verhältnis zur sendenden LED 1 c.

Zur weiteren Auswertung wird das Ausgangssignal der Additionsstufe 10 einem Synchrondemodulator 11 zugeführt. Das Steuersignal für den Synchrondemodulator wird vom Taktgenerator 100 abgenommen. Es entspricht im wesentlichen dem Sendesignal, berücksichtigt aber die in den Verstärkern 5 und 6 entstehende Phasenverschiebungen. Der Synchrondemodulator 11 zerlegt das Ausgangssignal der Additionsstufe 10 wieder in zwei, jeweils der LED 1b und 1d zugeordneten Einzelsignale 12, 13. Für eine eindeutige Entscheidung über die Bewegungsrichtung bzw. die Lage des Fingers 2 zum Sendeelement 1c werden die beiden Einzelsignale 12 und 13 miteinander im Komparator 14 verglichen. Das digitale Ausgangssignal S15 des Komparators 14 gibt eine eindeutige Aussage über die Position des reflektierenden Elements, im Verhältnis zum Sendeelement 1c, also ob sich der Finger 2 rechts oder links vom Mittelpunkt der LED 1 c befindet.

Zur Entscheidung, ab welcher Positionsveränderung ein Weiterschalten der leuchtenden LED analog zur Bewegung des Fingers 2 erfolgen soll, werden die Ausgangssignale 12 und 13 des Synchrondemodulators 11 in einem entsprechend analog arbeitenden Vergleicher 16 verglichen, z.B. mit einem Operationsverstärker. Das analoge Ausgangssignal S17 entspricht der horizontalen Abweichung des Fingers vom Mittelpunkt der sendenden LED 1c. Aus diesem Ausgangssignal wird in der weiteren Signalverarbeitung das Schaltsignal für den Positionszähler 23 (Fig. 7) gewonnen. Das digitale Ausgangssignal S15 dient dazu, dem Positionszähler 23 die entsprechende Zählrichtung vorzugeben. Eine Zählrichtung zu höheren Werten kann im Ausführungsbeispiel den Sendetreiber von der LED 1c zur LED 1d weiterschalten bei gleichzeitiger Umschaltung der Verstärker 5 und 6 von LED 1b und 1d hin zu 1c und 1e.

Zur Verhinderung einer unbeabsichtigten Verstellung durch versehentliches Berühren kann ein vorheriges "Antippen" des leuchtenden Elements zur weiteren Aktivierung der Verstellungsmöglichkeit vorgesehen werden. Dazu muss eine Information aus der vertikalen Bewegung des Fingers 2 auf das leuchtende Element zu bzw. von diesem weg gewonnen werden. Diese Information läßt sich der Additionsstufe 18 entnehmen, in der beide Signale der empfangenden LEDs addiert werden. Ein Synchrondemodulator 19 wertet das addierte Signal entsprechend aus und über die Bufferstufen 20 steht es als analoges Abstandssignal S21 zur Verfügung.

Fig. 7 zeigt die Auswertung der Signale S21, S15 und S17. Ein Fensterkomparator 22 liefert ein Ausgangssignal S22, wenn das Ausgangssignal S17, dass ja einen analogen Wert für die horizontale Position des Fingers im Verhältnis zur sendenden LED darstellt, einen im Fensterkomparator 22 vorgegebenen Wert über- bzw. unterschreitet. Dieser Wert wird erreicht, wenn das reflektive Element, also der Finger 2, eine Strecke seitlich vom Mittelpunkt des sendenden Elements (LED 1 c) hin zum benachbarten empfangenden Element (LED 1b oder 1d) bewegt wird, auch wenn die Strecke kleiner ist als die halbe Entfernung zwischen zwei benachbarten Elementen. Das Ausgangssignal S22 des Fensterkomparators 22 wird als Clock-Signal dem Positionszähler 23 zugeführt.

Die Entscheidung, ob der Positionszähler 23 nach oben oder unten zählen soll, was einer "Verlagerung" der leuchtenden LED nach links oder rechts entspricht, wird dem Ausgangssignal S15 des Komparators 14 entnommen. Das Ausgangssignal S23 des Positionszählers 23 wird der Steuereinheit 24 zugeführt. Mit ihr wird die dem Zahlenwert des Ausgangssignals S23 entsprechende Position der sendenden LED und ihrer wenigstens zwei mittelbar oder unmittelbar benachbarten Empfangs-LEDs oder Empfangselemente bestimmt.

Grundsätzlich soll die leuchtende LED ihre Position nicht schon verändern, wenn nur zufällig mit der Hand über die LED gewischt wird. Vielmehr soll zunächst manuell die Positionssensibilität aktiviert werden, bevor die leuchtende LED mit dem sich bewegenden Finger "mitläuft". Dazu werden die Ausgangssignale 7,8 in der Additionsstufe 18 zusammengefasst, synchron demoduliert und das so gewonnene Abstandssignal S21 in einer entsprechenden Auswerteschaltung 25 so aufbereitet, dass z.B. eine Positionsverschiebung erst nach einem ein- oder zweimaligen "Antippen" der leuchtenden LED freigegeben wird. Die Vorrichtung zur Antipp-Erkennung erkennt vorzugsweise ein Bewegungsmuster als Antippen, das die Annäherung eines Objekts, das abrupte Abbremsen des Objekts an einer angetippten Fläche sowie ein Verweilen auf der Fläche für eine vorgegebene Zeit t28 umfasst.

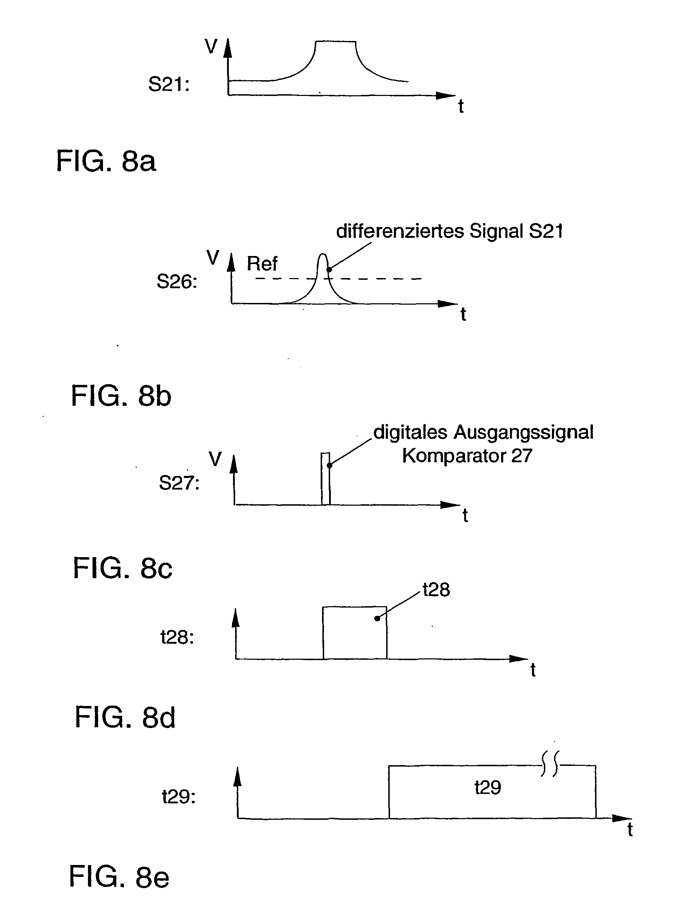

Dazu wird das Abstandssignal S21 im Ausführungsbeispiel durch das Hochpaßfilter 26 geführt, dass nur die höherfrequenten Spektralanteile des Abstandssignals S21 durchläßt. Diese Signalanteile entstehen nur dann, wenn eine schnelle Veränderung im Abstandssignal S21 gemäß Fig. 8a vorliegt. Das abrupte Abbremsen des Fingers auf einer translucenten Oberfläche oberhalb der LED-Reihe kann daher zu einem Ausgangssignal S26 führen, einem aus dem Abstandssignal S21 differenzierten Signal. Überschreitet dieses Ausgangssignal S26 gemäß Fig. 8b einen vorbestimmten Wert Ref, liefert der Komparator 27 ein digitales Ausgangssignal S27 (Fig. 8c) an einen ersten Timer 28 mit einer Timerzeit t28 von einigen hundert Millisekunden bis Sekunden (Fig. 8d). Nach Ablauf dieser kurzen Zeit wird Timer 29 gemäß Fig. 8e gestartet. Seine Laufzeit beträgt einige Sekunden. Das Ausgangssignal S29 gibt den Positionszähler 23 frei. Eine Veränderung des Zählerstandes retriggert (rt) dann den Timer 29. Wird die Position der leuchtenden LED innerhalb der Laufzeit t29 des Timer 29 nicht verändert, läuft die Zeit t29 ab und der Positionszähler 23 wird wieder gesperrt. Durch diese Schaltungsanordnung wird verhindert, dass durch eine unbeabsichtigte Bewegung die Stellung der leuchtenden LED in der LED-Reihe verändert wird. Erst nach einem "Antippen" kann durch erneutes Berühren der leuchtenden LED und Verschiebung des Fingers die Position der leuchtenden LED verschoben werden.

An dieser Stelle können alle erdenklichen Schaltungsanordnungen eingeführt werden, also auch Zähleranordnungen, die auch erst nach mehrmaligen Antippen der leuchtenden LED den Positionszähler 23 freigeben. Aus WO 01/54277 A1 ist eine - hier z.B. bevorzugt verwendbare - Anordnung bekannt, bei der eine Funktion erst geschaltet wird, wenn ein Finger die transluzente Oberfläche über einer LED schnell berührt (antippt) und mindestens eine bestimmte Zeit, z.B. 200 ms relativ unbewegt liegen bleibt.

Das digitale Ausgangssignal S23 des Positionszählers 23 steuert im weiteren die Steuereinheit 24. In ihr werden das Sendeansteuersignal entsprechend auf die LEDs sowie die beiden Verstärkereingänge der Verstärker 5,6 (Fig. 6) auf die den Sendedioden benachbarten LEDs verteilt. Weiterhin kann das Ausgangssignal S23 des Positionszählers 23 (Fig. 7) zur Steuerung einer beliebigen Wertsteuerung einer Regel/Stelleinheit 30 herangezogen werden, z.B. für eine Lautstärkeregulierung.

Wird die leuchtende LED in eine der beiden Endpositionen "verschoben", können allerdings nicht mehr die wenigstens zwei benachbarten LEDs als Empfänger dienen, sondern nur noch eine. Treten dabei parasitäre Reflexionen, z.B. an der translucenten Oberfläche auf, so bekommt die einzelne Empfangs-LED, z.B. LED 1a ein Signal ähnlich des eines "verschobenen" Fingers. Im Extremfall würde dieses ungewünschte Signal dazu führen, dass die Ansteuerung von LED 1 a immer wieder zurück auf LED 1 b springt.

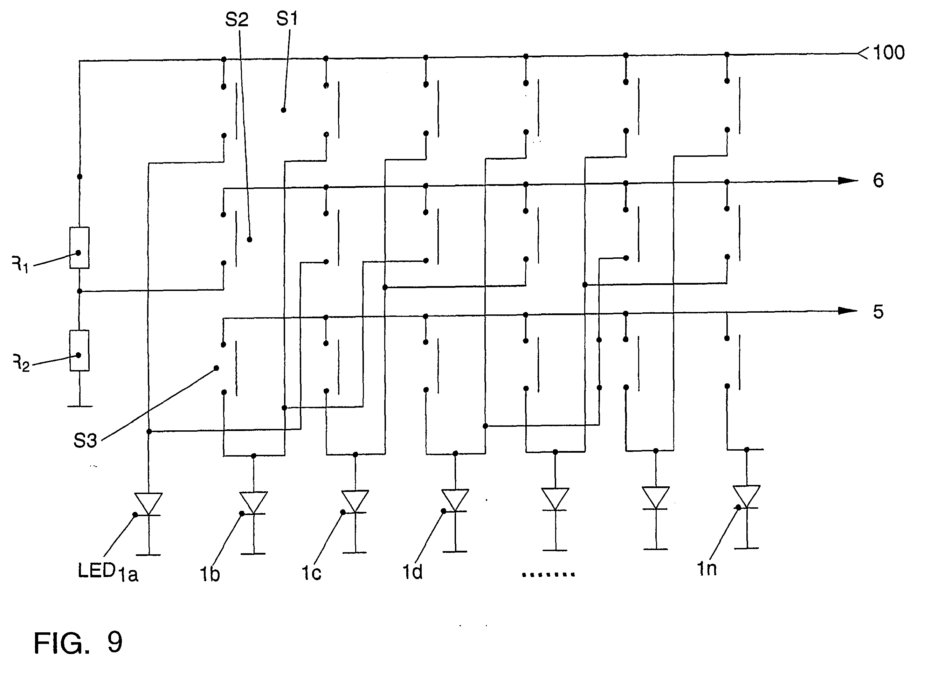

Um dies zu verhindern, wird bei Ansteuerung von LED 1a dem Verstärker 6 (Fig. 6) ein simuliertes "Lichtsignal" geboten. Fig. 9 zeigt dazu die entsprechende Umschaltung. Schalter S1, S2 und S3 werden über die Steuereinheit 24 vom Steuersignal S23 des Positionszählers 23 (Fig. 7) angesteuert. Schalter S1 legt den Ausgang des Taktgenerators 100 an die entsprechende LED. Im Ausführungsbeispiel in Fig. 9 an die LED 1 a, also ganz links außen. Schalter S3 legt den Verstärkereingang vom Verstärker 5 an die rechts benachbarte LED 1b. Schalter S2 legt den Verstärkereingang vom Verstärker 6 an einen Spannungsteiler R₁/R₂, der am Ausgang des Taktgenerators 100 angeschlossen ist. Das Teilerverhältnis des Spannungsteilers R₁/R₂ ist so zu bemessen, dass die Größe des heruntergeteilten Sendetaktsignales S100 geringfügig größer ist als das durch parasitäre Reflexion an der translucenten Oberfläche entstandene Empfangssignal von LED 1 b.

Dadurch wird gewährleistet, dass bei Bewegung des Fingers über die LED-Reihe, z.B. von der Mitte her nach links über LED 1a hinweg, diese als letzte LED in der Reihe leuchtet. Wird dagegen der Finger von der Seite her über die leuchtende LED 1a hinweg zur Mitte der LED-Reihe bewegt, so wird in der Position des Fingers 2 zwischen LED 1a und LED 1 b die Reflexion der sendenden LED 1a am Finger in der LED 1b ein größeres Signal hervorrufen als es vom Spannungsteiler R₁/R₂ geliefert wurde. Die Phasenlage des Signals S10 (Fig. 6) kehrt sich somit um und die Ansteuerung von LED 1a geht auf LED 1b über, bzw. folgt dem Finger 2.

Mit der bisher beschriebenen Anordnung zur Steuerung der LED-Reihe kann verständlicherweise das Licht nur in jeweils eine Richtung mit dem Finger verschoben werden. Grund dafür ist die Tatsache, dass ab einer, durch die festgelegten Schwellwerte im Fensterkomparator 22 (Fig. 7) bestimmten Entfernung des Fingers vom Mittelpunkt der aktuell leuchtenden LED das Licht vor den bewegten Finger 2 umspringt. Wird durch kontinuierliche Fingerbewegung die jetzt leuchtende LED wieder überstrichen, schaltet das Licht vor den Finger zur nächsten LED usw. Stoppt jedoch nach einem Umspringen der Finger 2 und wird zurückbewegt, verbleibt die zuletzt leuchtende LED in ihrer letzten Position. Zur Umkehr der Bewegungsrichtung muss der Finger jetzt, in Bewegungsrichtung gesehen, vor die leuchtende LED gesetzt werden. Mit nun inverser Bewegungsrichtung muß sie überstrichen werden. Jetzt folgt die Anzeige wieder der Fingerposition.

Da dies aber im allgemeinen Gebrauch unpraktisch ist, wird zwischen dem Vergleicher 16 (Fig. 6) und dem Fensterkomparator 22 (Fig. 7) eine Schaltung eingefügt, die dafür sorgt, dass der Lichtpunkt immer direkt der Fingerbewegung folgt. Diese Schaltungsanordnung nutzt den Effekt, dass beim Umschalten von einer LED zur nächsten LED sich die Polarität des Zähler-Steuersignals (Ausgangssignal S15) und der analogen Ausgangsspannung des Vergleichers 16 (Ausgangssignal S17) umkehrt. Dies ist einfach zu erklären, wenn man bedenkt das die Umschaltung erfolgt, wenn sich der Finger z.B. nach rechts von der leuchtenden LED wegbewegt und die rechts von dieser LED befindliche LED eine erhöhte Reflexion wahrnimmt. Überschreitet dieser Wert eine vorbestimmte Größe, dann liefert der Fensterkomparator 22 ein entsprechendes Signal und der Positionszähler 23 (Fig. 7) zählt einen Wert "hoch" in diesem Fall also nach "rechts". Die ursprünglich leuchtende LED "springt" von der gegenüber dem Finger 2 linken Position zur Position rechts vom Finger. Die ursprünglich als Licht aussendendes Element beschaltete LED vertauscht ihre Funktion und wird zum Lichtempfänger, der sich aber nun links vom sendenden Element befindet. Da sich der Finger 2 aber noch in annähernd gleicher Position befindet, bekommt nun die links vom sendenden Element befindliche LED eine gegenüber der rechts vom sendenden Element befindlichen LED erhöhte Reflexion. Dies bedeutet aber am Ausgang der Addierstufe 10 (Fig. 6) eine Umkehrung der Phase und somit auch eine Umkehrung der Polarität des digitalen Ausgangssignals S15 und auch des analogen Ausgangssignals S17.

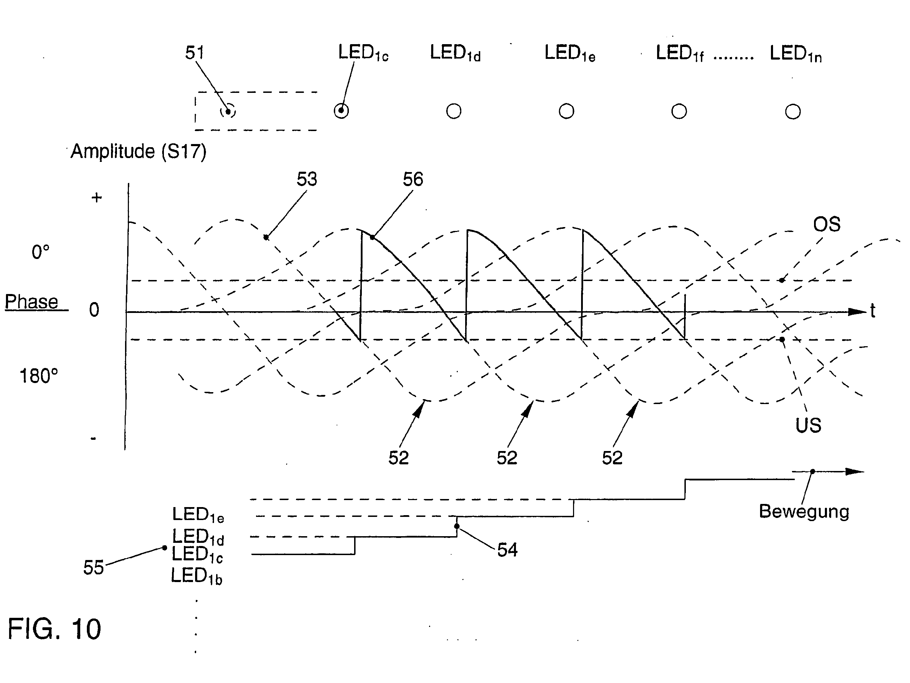

Fig. 10 beschreibt die Phasen und Amplitudenbeziehung des analogen Ausgangssignals S17 (Fig. 6) des Vergleichers 16 in einem solchen Fall. Position 51 bzw. LED 1a...1n zeigt die mechanische Anordnung der LEDs, 52 die zugehörige Signalwerte des analogen Ausgangssignals S17 des Vergleichers 16. 53 entspricht im dargestellten Fall einem Signal, wenn LED 1c leuchtet. Wird bei einer Fingerbewegung nach rechts mit dem Ausgangssignal S 17 des Vergleichers 16 der vorgegebene untere Schwellwert US unterschritten, zählt der Positionszähler 23 um einen Zähler hoch (54 in Fig. 10). Die Zählerstellung bestimmt, welche LED getaktet angesteuert wird (55 Fig. 10). Die fett durchgezogene Linie 56 zeigt den Verlauf des Ausgangssignal S17 des Vergleichers 16, wenn ein Finger 2 von links nach rechts über die LED-Reihe bewegt wird.

Im Fall des Umschaltens wird der Schwellwert OS des Fensterkomparators 22 wieder - in anderer Polarität - überschritten und dadurch der Positionszähler 23 wieder zurückzählen. Eine ständige Umschaltung der LED-Positionen symmetrisch zum Finger 2 wäre die Folge. Die leuchtenden LEDs folgen dem Finger 2 in der Weise, das bei Position des Fingers mittig auf einer LED nur diese leuchtet, während bei Positionierung des Fingers zwischen zwei LEDs beide in schnellem Wechsel leuchten.

Aus Toleranzgründen kann jedoch nach einem ersten Überschreiten des Schwellwertes US ein Umschalten erfolgen, worauf wiederum der Schwellwert OS überschritten wird und ein zweites Umschalten zurück zur Ursprungsposition erfolgt, jedoch der Schwellwert US dieses Mal nicht unterschritten wird, so dass ein weiteres Umschalten nicht unbedingt gewährleistet ist. Bei Bewegung des Fingers über die LED-Reihe kann dadurch die Anzeige "stehenbleiben".

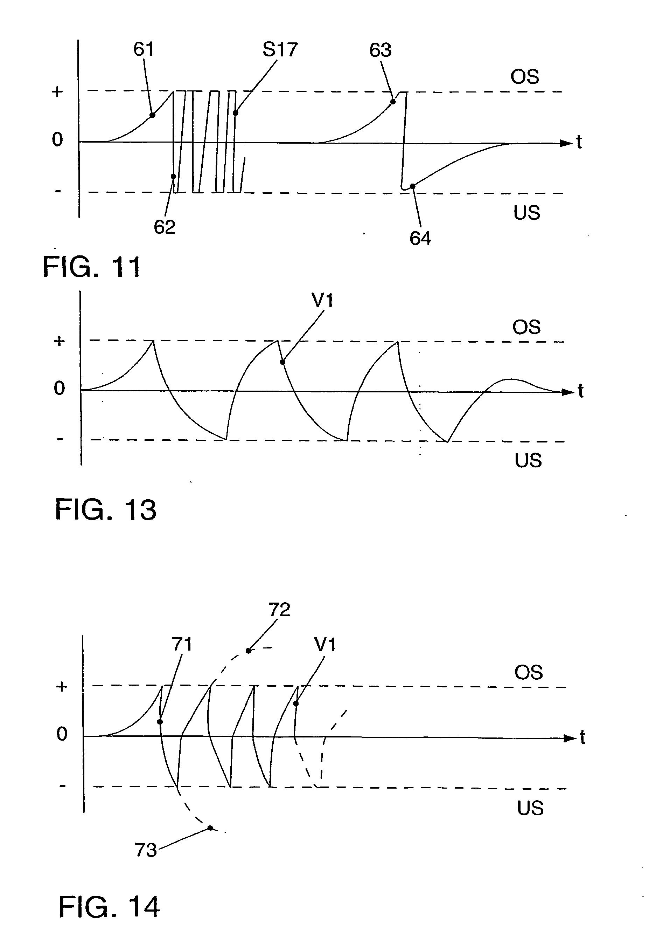

Fig. 11 zeigt das analoge Ausgangssignal S17 (Fig. 6) des Vergleichers 16 der Positionserkennung. Im Abschnitt 61 bewegt sich der Finger 2 von der Mitte der sendenden LED z.B. nach rechts, das analoge Ausgangssignal S17 des Vergleiches 16 steigt entsprechend an. Trifft es auf den oberen Schwellwert OS, wird die LED-Ansteuerung zur nächsten, rechts liegenden LED weitergeschaltet. Dadurch kehrt sich das Vorzeichen des Ausgangssignals um (62) und das Signal erreicht den unteren Schwellwert US. Die LED-Ansteuerung schaltet zurück zur vorherigen LED. Selbstverständlich schalten auch die als Empfänger beschalteten LEDs entsprechend um.

Stellen sich unerwünschte Toleranzen ein, z.B. durch einen Kratzer auf der translucenten Oberfläche, kann die Situation eintreten, dass die LED zwar "umspringt", weil der obere Schwellwert OS einwandfrei erreicht wurde (63, Fig. 11), danach jedoch der untere Schwellwert US nach Wechsel des Vorzeichens nicht mehr unterschritten wird (64, Fig. 11). Kehrt der Bediener in dieser Situation die Richtung der Fingerbewegung um, weil z.B. der Bediener von diesem eingestellten Wert wieder zurück will, erfolgt keine Reaktion der Anzeige, sie verbleibt trotz Bewegung des Fingers in ihrer Position. Diese Fehlfunktion kann auf einfache Weise dadurch verhindert werden, dass nach jedem Wechsel der LED das Ausgangssignal S17 in seiner vollen Größe von Null aus genutzt wird. Bisher hatte es den Spannungsbereich vom oberen Schwellwert OS, durch Null hindurch zum unteren Schwellwert US zu durchlaufen. Bei einem zweiten Schaltvorgang zurück zur Ausgangsstellung bestand ein Unsicherheitsfaktor beim erneuten Erreichen des unteren Schwellwertes US. Wird jedoch das momentane Ausgangssignal S17 des Vergleichers 16 im Umschaltmoment auf "0" referenziert, beginnt das Δ des Signals bei Null und überschreitet somit den jeweiligen Schwellwert mit doppelter Amplitude, was eine unbedingte Schaltsicherheit gewährleistet.

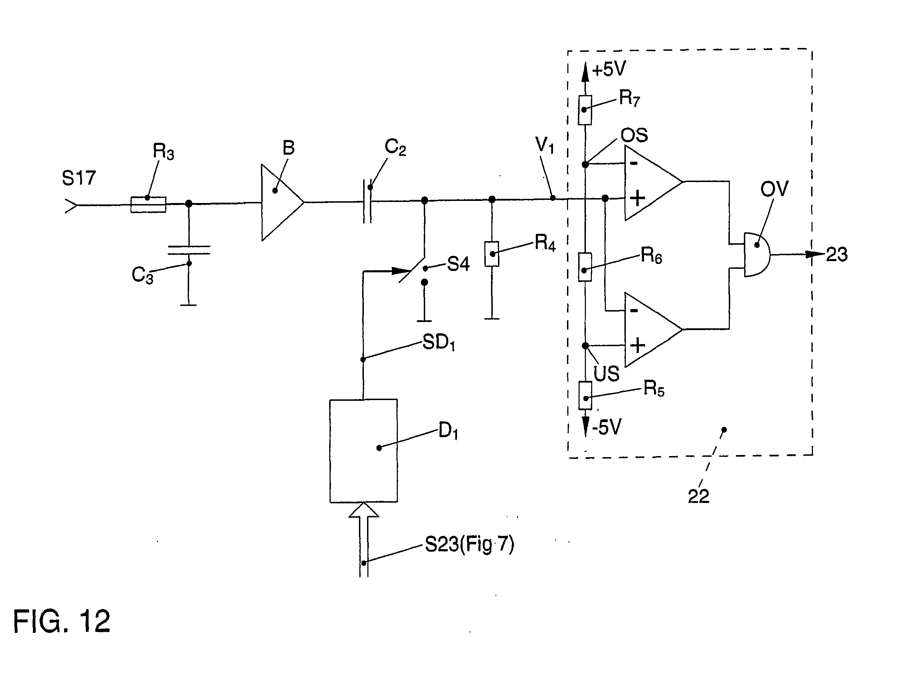

In Fig. 12 bildet ein aus R₃ und C₃ ausgeführter Tiefpaß eine Verzögerung für das Signal S17 des Vergleichers 16. Kondensator C₂ bildet zusammen mit Schalter S4 eine Referenziereinheit. Buffer B dient nur zur elektrischen Trennung der Referenziereinheit C₂/S4 vom Tiefpaß R₃/C₃. D1 stellt eine Differenziervorrichtung für ein Zählsignal des Positionszählers 23 dar. Bei jeder Veränderung des Zahlenwertes S23 des Positionszählers 23 wird über Signalleitung SD1 ein kurzer Impuls an Schalter S4 gelegt und bei geschlossenem Schalter S4 der Kondensator C₂ auf Null entladen. Das Ausgangssignal S17 des Vergleichers 16 hat auf Grund der verzögernden Tiefpaßwirkung des Tiefpaß R₃/C₃ am Ausgang des Buffers B während der Schaltzeit von Schalter S4 nur eine unwesentliche Änderung erfahren, so dass nahezu das gesamte Δ des Ausgangssignals S17 am Eingang des Fensterkomparators 22 zur Geltung kommen kann. Selbstverständlich ist Null nur ein Beispiel für einen vorgegebenen oder vorgebbaren Wert. Eine Referenzierung kann auch auf einen anderen bestimmten vorgegebenen oder vorgebbaren Wert erfolgen, so dass nach dem Umschalten mit einem Teil des Ausgangssignals S17 der nächste Schwellwert US oder OS erreicht wird.

Mit der Schaltung nach Fig. 12 wird gewährleistet, dass jede Fingerbewegung einwandfrei erfaßt wird und die leuchtende LED immer der Fingerbewegung folgt. Dabei leuchtet nur eine LED, wenn der Finger sich mittig auf ihr, und zwei benachbarte LEDs, wenn er sich zwischen ihnen befindet. Im letzten Fall wechselt die Stellung der leuchtenden LED wechselseitig mit einer durch den Tiefpaß R₃/C₃ bestimmten Frequenz. Bei entsprechender Bemessung kann sie höher liegen als mit dem Auge wahrnehmbar, so dass ein kontinuierliches Leuchten wahrgenommen wird. Analog zur Fingerstellung zwischen den beiden LEDs stellt sich eine entsprechende Intensitätsverteilung der Leuchtstärke ein. Im Ausführungsbeispiel hat R₃ 10 kΩ, R₄ 1 MΩ, R₅ 10kΩ, R₆ 1kΩ und R₇ 10kΩ. C₂ hat einen Wert von 0,1 µF und C₃ einen Wert von 10 nF.

Fig. 13 zeigt das analoge Ausgangssignal S17 am Ausgang des Buffers B (Fig. 12), wenn ein Finger über die LED-Reihe bewegt wird, ohne dass Schalter S4 betätigt wird. Fig. 14 zeigt das gleiche analoge Ausgangssignal S17 jedoch am Eingang des Fensterkomparators 22, wenn der Schalter S4 bei jedem Positionswechsel das Signal S17 auf Null referenziert (71 in Fig. 14). Die gestrichelten Linien 72, 73 entsprechen dem Signal, wenn kein weiteres Umschalten erfolgen würde. Es ist deutlich zu sehen, dass das Ausgangssignal S17 nach Referenzierung 71 den Schwellwert OS bzw. US sicher überschreiten würde und somit zu einem einwandfreien Schaltvorgang führt. Die steile Flanke entsteht bei der Referenzierung 71, wenn Schalter S4 kurzzeitig während des Positionsschaltvorganges den Kondensator auf "0" entlädt. Damit die Eingangsspannung des Fensterkomparators 22 nicht aufgrund des geöffneten Schalters S4 "wegdriftet", ist parallel zum Schalter S4 ein hochohmiger Widerstand R₄ geschaltet. Die Gleichwertentkoppelung über Kondensator C₂ und Widerstand R₄ verhindert zusätzlich auch den Einfluß von Störgrößen, z.B. einer Asymmetrie am Ausgang des Vergleichers 16 aufgrund von Kratzern auf der translucenten Oberfläche. Die durch die Störgröße auftretende Signalabweichung von Null bei entferntem Finger wird nach dem Kondensator C₂ automatisch zu Null referenziert.

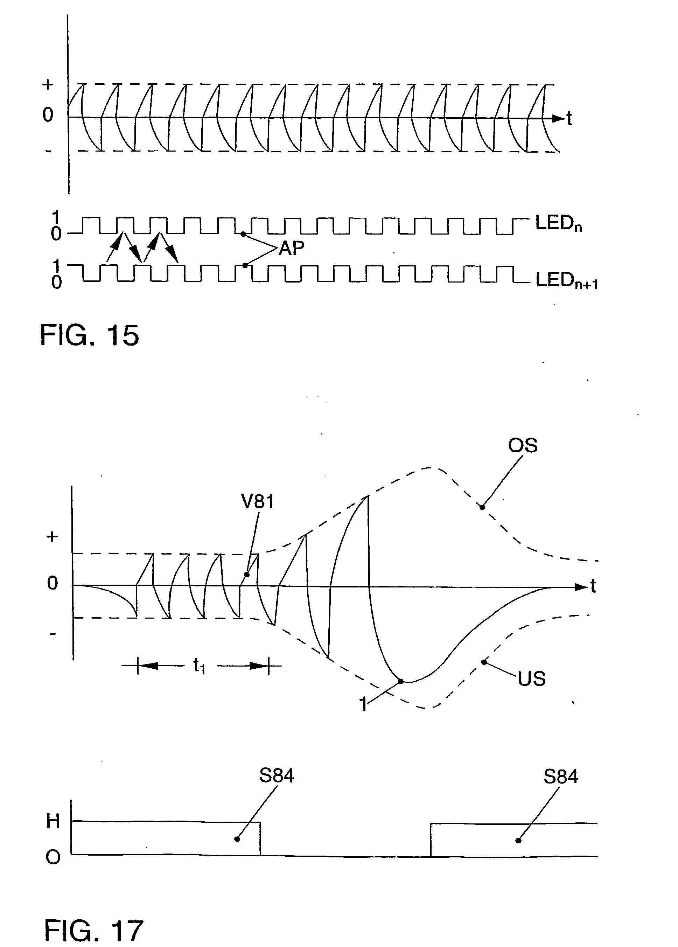

Oft sollte jedoch bei einer Fingerstellung zwischen 2 benachbarten LEDs zur leichteren Auswahl nur eine der beiden LEDs leuchten. Und zwar diejenige, die dem steuernden Finger am nächsten ist. In dem bisher beschriebenen Ausführungsbeispiel leuchten beide LEDs abwechselnd, ausführungsgemäß auch so schnell, dass es für das Auge wie ein kontinuierliches Leuchten erscheint. Fig. 15 zeigt das vom Ausgangssignal S17 abgeleitete Signal V1 am Eingang des Fensterkomparator 22 in Fig. 12, wenn sich der Finger 2 zwischen zwei LEDs befindet. AP zeigt die Aktivierungsphasen der beiden LEDs n und n+1.

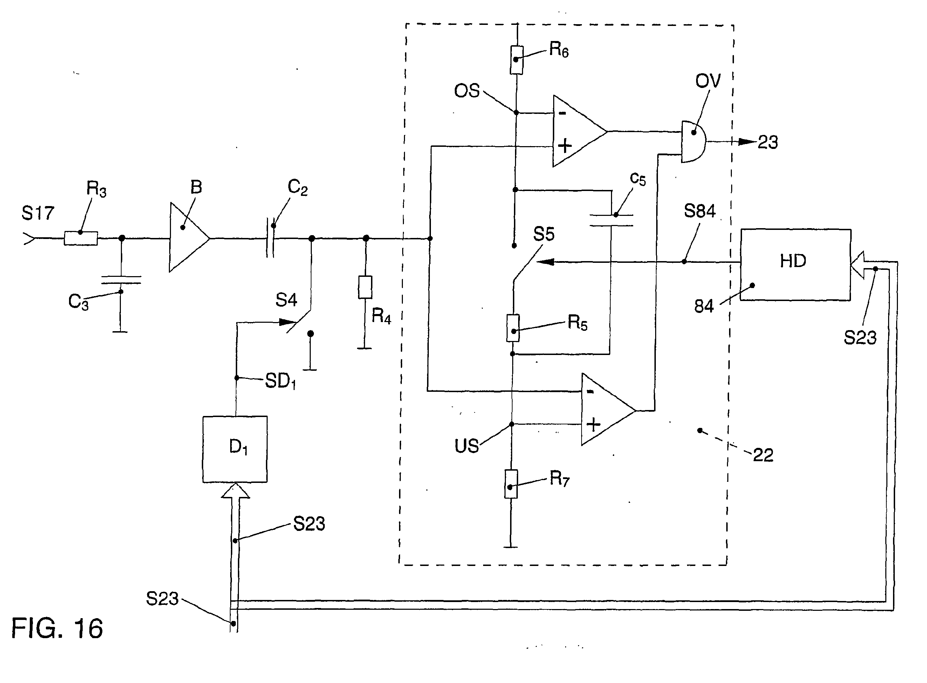

Damit in dieser Situation eine Entscheidung für eine der beiden LEDs getroffen werden kann, wird mit einem Hysteresedetektor 84 (Fig. 16) als Entscheidungshilfsmittel ein Steuersignal S84 für die beiden Schwellwerte OS und US erzeugt. Der Hysteresedetektor 84 überwacht den Zählwert des Positionszähler 23 (Fig. 7) auf periodische Zählvorgänge mit maximalen Zählschritten +/- 1. Erscheint eine solche Schaltfolge im Zählwert S23 für eine Periodenzahl (z.B. größer 5) in einer vorbestimmten Zeit, öffnet der Hysteresedetektor 84 den Schalter S5. Dies ist immer dann der Fall, wenn sich ein Finger zwischen zwei benachbarten LEDs befindet. Öffnet Schalter S5, lädt sich der Kondensator C₅ vom durch den Spannungsteiler R₅, R₆, R₇ vorgegebenen Schwellwert auf, also zu einem höheren Potential hin. Dabei steigt der obere Schwellwert an, während der untere absinkt.

Die Steuereinrichtung 24 schaltet also zwischen benachbarten Leuchtdioden hin- und her, wenn der Finger 2 unverändert zwischen benachbarten Leuchtdioden stehen bleibt, und erhöht die Empfindlichkeit für die Positionserfassung, bis ein vorgegebener Wert überschritten ist. Damit wird bei mehrmaligem Hin- und Herschalten ein Entscheidungshilfsmittel aktiviert, das solange das Empfangselement immer unempfindlicher schaltet, bis die dem Objekt näher liegende Leuchtdiode eindeutig bestimmbar ist. Anschließend geht das Entscheidungshilfsmittel wieder in den für die Erfassung einer weiteren Bewegung des Fingers 2 empfindlichen Zustand über.

Fig. 17 zeigt die Veränderung des Schwellwertes OS und US. Im Zeitraum t₁ hat der Hysteresedetektor 84 mindestens fünf Schaltvorgänge zwischen zwei benachbarten LEDs erkannt und das Steuersignal S84 auf "low" gesetzt, so dass der Schalter S5 geöffnet wurde. Dieser Zustand dauert so lange an, bis das Signal V1 nicht mehr die Schwellwerte überschreitet (81 Fig. 17) und nur noch eine LED leuchtet. Dies wird vom Hysteresedetektor 84 registriert und er schließt Schalter S5 wieder. Die Zeitkonstante des Kondensators C₃ und des Widerstands R₅ ist so zu bemessen, dass sie größer ist als die Zeitkonstante von C₂ und R₄, um eine einwandfreie Referenzierung des Signals V1 zu gewährleisten. Jetzt hat die Schaltungsanordnung wieder ihre ursprüngliche Empfindlichkeit für die Detektion der Fingerbewegung erreicht. Die Umschaltung der Schwellwerte OS und US kann so schnell erfolgen, dass ein gleichzeitiges Leuchten von zwei LEDs nur so kurz während der Fingerbewegung auftritt, dass es mit dem Auge nicht wahrgenommen wird.

Für einen besseren Komfort kann zusätzlich noch eine - hier nicht näher bezeichnete - Schaltung eingefügt werden, die bei einer versehentlichen Verschiebung des Fingers 2 beim Entfernen zu keiner Positionsverschiebung der LEDs und somit des gewünschten Regelwertes führt. Dazu wird das Abstandssignal S21 ausgewertet. Zeigt dies eine Entfernung des Fingers bei gleichzeitiger Positionsänderung an, so wird diese Positionsänderung entsprechend ignoriert, z.B. durch Sperren des Positionszählers 23. Vorzugsweise kann auch ein Wert der Abweichung vom letzten Signal von z.B. 10 % vorgegeben werden. Wird dieser Wert beim Entfernen des Objekts überschritten, wählt die Steuereinrichtung 24 die Leuchtdiode aus, an der das Objekt zuletzt länger als eine vorgegebene Verweilzeit, z.B. t28 verweilt hat.

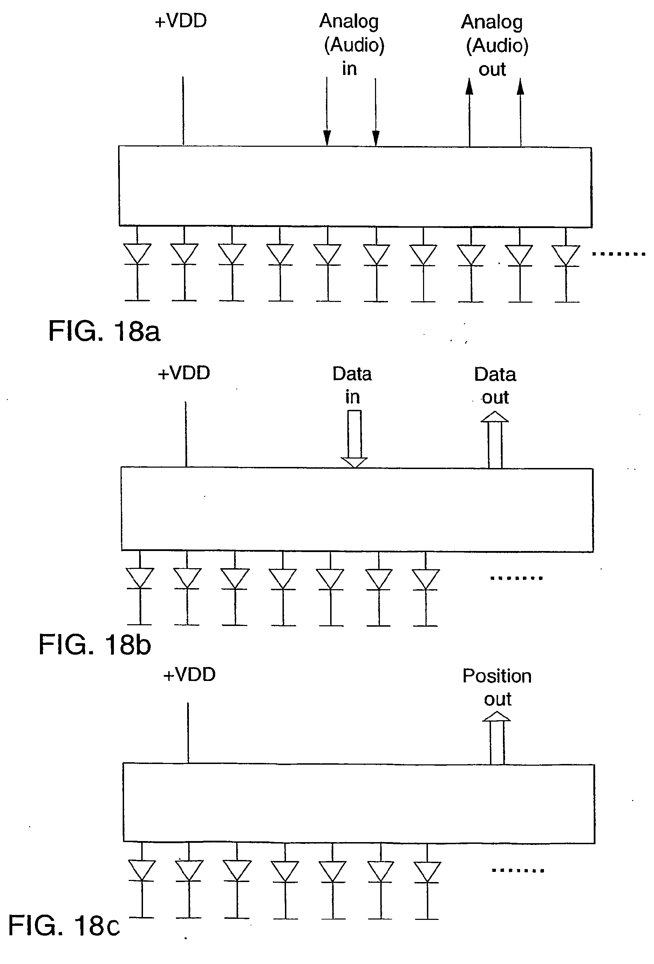

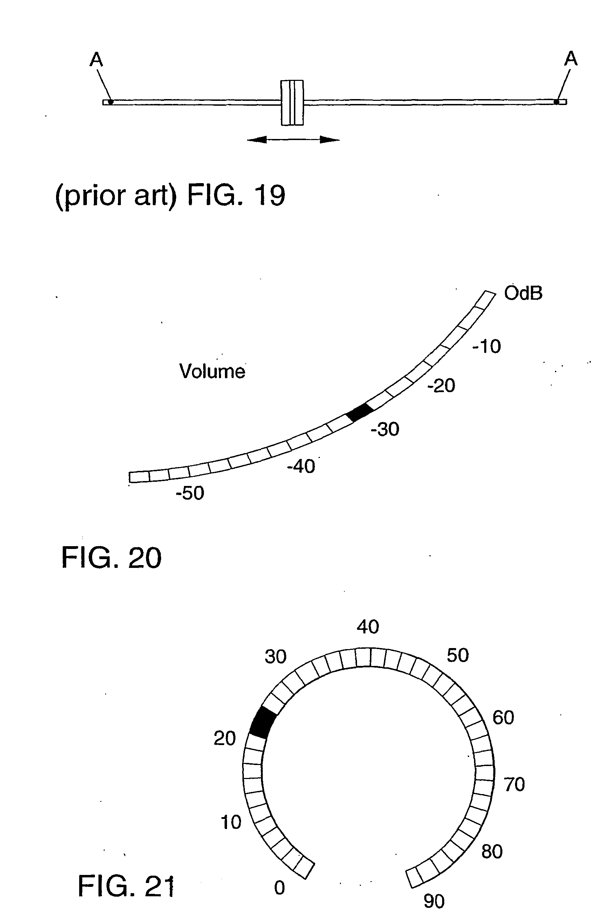

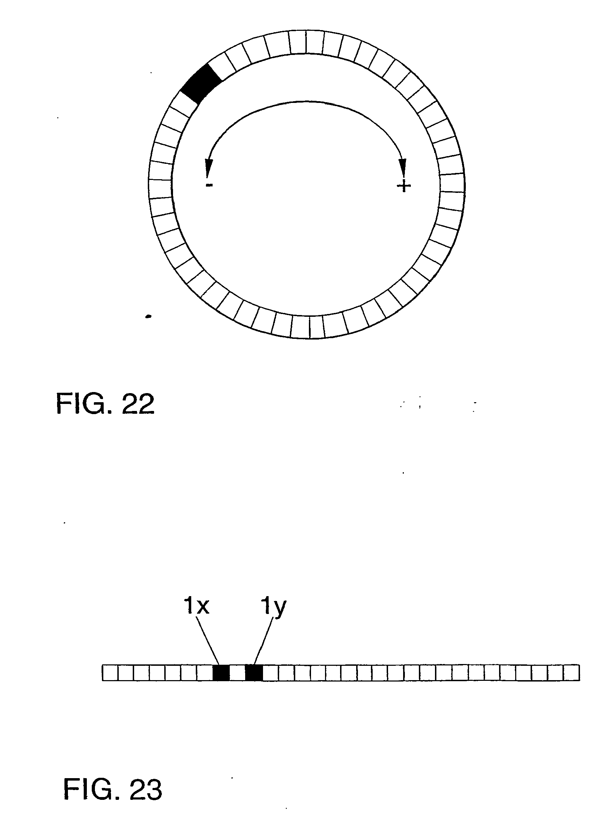

Trotz der scheinbar umfangreichen Signalauswertung ist eine Berührungs-sensitive LED-Reihe als IC (Integrated Circuit) mit externen LEDs durchaus einfach zu realisieren. Eine derartige Anordnung kann z.B. direkt als "Lautstärkeregler" eingesetzt werden, einen digitalen Datenstrom bearbeiten oder auch nur die "Position" ausgeben (Fig. 18a,b,c). Es können auch Maßnahmen getroffen werden, damit nach dem Abschalten der Versorgungsspannung der aktuelle Zählerstand des Positionszählers 23 bis zum nächsten Aktivieren erhalten bleibt. Im Gegensatz zu mechanischen Schiebereglern (Fig. 19), die in der Regel einen geraden Schiebebereich von einem Punkt A zu einem Punkt B aufweisen, kann die Berührungs-sensitive LED-Reihe in jeglicher gewünschten Darstellungsform realisiert werden z.B. bogenförmig oder rund (Fig. 20/Fig.21). Zur Verlängerung des Arbeitsweges können LED-Reihen auch kaskadiert werden. Verbindet man entsprechend die Funktion einer letzten LED in einer Reihe funktionell mit einer ersten LED der selben Reihe, kann auf einfache Weise ein virtueller Drehknopf erzeugt werden (Fig. 22).

In der Regel wird die Regel/Stelleinheit 30 nur eine Anzeige, d.h. nur ein leuchtendes Element aufweisen. Selbstverständlich kann jedoch das Prinzip - 1 Sender, 2 Empfänger um den Sender in geringem oder großem, gleichmäßigem oder ungleichmäßigem Abstand gruppiert - auch umgedreht werden. Dann senden zwei Sender wechselseitig, ein mittig zwischen den beiden Sendern angeordneter Empfänger wertet das reflektierte Signal aus. Eine solche Schaltungsanordnung, jedoch ohne die für die Berührungs-sensitive LED-Reihe nötige Positionsveränderung ist in der älteren DE-A 101 33 823 beschrieben. Durch eine automatische Ausregelung des Empfangssignals zu Null werden in oben genannter Schaltungsanordnung möglicherweise störende Fremdlichteinflüsse vollständig vermieden.

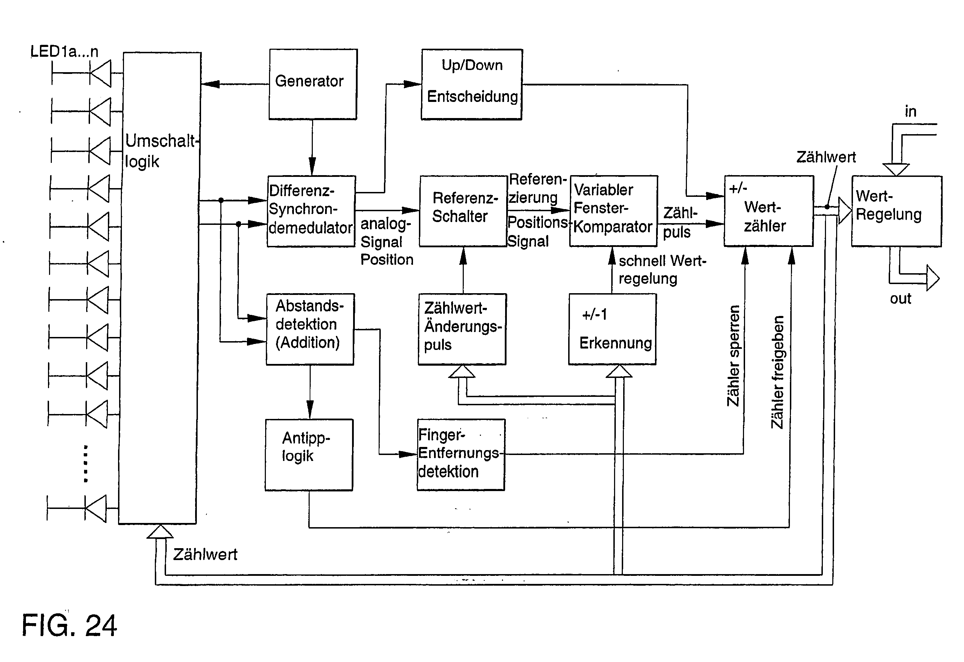

Bei einer Anordnung mit zwei Sendeelementen wird der Finger auf die "Lücke" zwischen den beiden Sendeelementen positioniert und dann durch Bewegung des Fingers in die gewünschte Position verschoben. Selbstverständlich kann auch hier ein "Antippen" der "Lücke" zuerst eine weitere Möglichkeit des Verschiebens aktivieren (Fig. 24).

Fig. 25 zeigt ein vollständiges Blockdiagramm der "Berührungssensitiven LED-Reihe".

Unter Umständen kann es auch erwünscht sein, eine gewählte Einstellung der Regel/Stelleinheit schnell zu ändern. Bisher war meist von einem Antippen der leuchtenden LED oder der Lücke die Rede. Es ist allerdings auch möglich die gesamte LED-Reihe nach erfolgter Einstellung, also wenn z.B. erkannt wurde, dass sich das betätigende Objekt entfernt hat, in regelmäßigen Intervallen z.B. mit einer für das menschliche Auge nicht sichtbaren Frequenz anzusteuern, um zu überprüfen, ob und wo sich ein Objekt nähert oder wo angetippt wird, und dort z. B. nach dem Antippen die LED als Anzeige zu übernehmen und auch die Regel/Stelleinheit entsprechend anzusteuern.

### Bezugszeichenliste

- 1a ... 1n: Leuchtdioden (LED)
- 2: Finger
- 2a ... 2n: Verstärker
- 3a ... 3n: Treiber
- 3,4: DC-Kompensation
- 5,6: Verstärker
- 7,8: Ausgangssignale
- 9: Invertierungsschaltung
- 10: Additionsstufe
- S10: Signal
- 11: Synchrondemodulator
- 12,13: Einzelsignale
- 14: Komparator
- S15: digitales Ausgangssignal
- 16: Vergleicher
- S17: analoges Ausgangssignal
- 18: Additionsstufe
- 19: Synchrondemodulator
- 20: Bufferstufe
- S21: Abstandssignal
- 22: Fensterkomparator
- S22: Ausgangssignal
- 23: Positionszähler
- S23: Zählwert
- 24: Steuereinheit
- 25: Auswerteschaltung
- 26: Hochpaßfilter
- S26, S27: Ausgangssignal
- 27: Komparator
- 28,29: Timer
- 30: Regel/Stelleinheit
- 37: Scheibe
- 44,45: Signalverteilungsstufen
- 47: Richtungsentscheidungs- einheit
- 51: Position der LED (Fig. 10)
- 52: Signalwert S17
- 53: Signal von LED 1 c
- 54: Zähler
- 55: Zählerstellung
- 56: Linie in Fig. 10
- 61: Abschnitt in Fig. 11
- 62,63: Positionen in Fig. 11
- 71: Referenzierung
- 72,73: Linien
- 81: Abschnitt in Fig. 17
- 84: Hysteresedetektor
- S84: Steuersignal
- 91: Zählwerk
- 92: Anzeigentreiber
- 93: Steuervorrichtung
- 94,95: analoges Audiosignal
- 100: Taktgenerator
- S100: Sendesignal an LED
- 200: Inverter
- 300: Verstärker (Fig. 3)
- AP: Aktivierungsphase
- B: Buffer
- C₂, C₃: Kondensator
- D₁: Differenziervorrichtung
- LED: Leuchtdiode
- R₁/R₂: Spannungsteiler
- R₃/C₃: Tiefpass
- R₄: Widerstand
- R₅, R₆, R₇: Spannungsteiler
- R₁₀: Vorwiderstand (Fig. 3)
- rt: retriggern von 29 in Fig. 7
- S1,S2,S3,S4,S5: Schalter
- Sa,Sb: Schalter
- Sts: Steuersignal
- t₁: Zeitraum
- tₓ, t_{y}: Phasen
- T1,T2: Tasten
- US,OS: unterer und oberer Schwellwert
- V1: Signal

## Patentansprüche

1. Schaltung mit einer optoelektronischen Anzeigeeinheit zur diskreten Anzeige der Einstellung einer Regel-/Stelleinheit (30) mit
- wenigstens einem Erfassungselement zur Erfassung der Betätigung der Regel-/Stelleinheit (30) mittels einem Objekt, wie z. B. einem Finger (2), zur Änderung der Einstellung der Regel/Stelleinheit, wobei das Erfassungselement bei Betätigung ein der gewünschten Änderung entsprechendes Ausgangssignal (S23) liefert,
- mehreren Lichtstrahlung aussendenden Leuchtdioden (1a,...,1n), die als Anzeigeelemente der Anzeigeeinheit ausgebildet sind,
- einer Steuereinrichtung (24), die in Abhängigkeit des vom Erfassungselement erzeugten Ausgangssignals wenigstens eine der Leuchtdioden (1a,...,1n) zur Anzeige der jeweiligen Einstellung als auch die Regel/Stelleinheit (30) zur Änderung der Einstellung ansteuert,
**dadurch gekennzeichnet, dass** die Steuereinrichtung (24) wenigstens eine der Leuchtdioden, die Erfassungselemente als auch die Regel/Stelleinheit (30) auf Grund des Ausgangssignals (S23), das in Abhängigkeit der Bewegung des Objekts relativ zu der Lichtstrahlung aussendenden Leuchtdiode (1c) gebildet ist, der Bewegung des Objekts folgend ansteuert und dass entweder wenigstens zwei für die Lichtstrahlung der Leuchtdioden (1a,...,1n) empfindliche Empfangselemente vorgesehen sind, die als Erfassungselemente die von wenigstens einer Leuchtdiode (1c) ausgesandte und von dem Objekt (2) reflektierte Lichtstrahlung erfassen, oder dass wenigstens ein für die Lichtstrahlung der Leuchtdioden (1a,...,1n) empfindliches Empfangselement vorgesehen ist, das als Erfassungselement die von wenigstens zwei Leuchtdioden (1c) ausgesandte und von einem Objekt (2) reflektierte Lichtstrahlung erfasst, wobei in beiden Fällen die Steuereinrichtung (24) das oder die Empfangselement(e) (1b, 1d), das neben der die Lichtstrahlung aussendenden Leuchtdiode (1c) angeordnet ist, auf das nächste Empfangselement und die Leuchtdiode auf die nächste Leuchtdiode in derselben Richtung weiterschaltet, sobald die Steuereinrichtung (24) die Anzeigeeinheit aufgrund des Ausgangssignals (S23)weiterschaltet.

2. Schaltung nach Anspruch 1, **dadurch gekennzeichnet, dass** die Richtung der Bewegung entlang der Reihe der Leuchtdioden (1a,...,1n) ist.

3. Schaltung nach Anspruch 1 oder 2, **dadurch gekennzeichnet, dass** das Empfangselement eine der Leuchtdioden (1b,1d) ist, die zumindest zeitweise so angesteuert ist, dass sie bei Beleuchtung eine Spannung erzeugt.

4. Schaltung nach einem der vorhergehenden Ansprüche, **dadurch gekennzeichnet, dass** die Leuchtdioden (1a,...,1n) zeitsequentiell als Sender und Empfangselement betrieben sind.

5. Schaltung nach einem der vorhergehenden Ansprüche, **dadurch gekennzeichnet, dass** diejenigen Leuchtdioden (1b,1d), die der die Lichtstrahlung aussendenden Leuchtdiode (1c) unmittelbar benachbart sind, als Empfangselement betrieben sind, und dass, sobald die Steuereinrichtung (24) die Anzeigeeinheit aufgrund des Ausgangssignals (S23) auf die nächste Leuchtdiode weiterschaltet, auch die benachbarten als Empfangselement betriebenen Leuchtdioden in derselben Richtung weiterschalten.

6. Schaltung nach einem der vorhergehenden Ansprüche, **dadurch gekennzeichnet, dass** die von der Leuchtdiode (1c) ausgesandte Lichtstrahlung von einem Taktgenerator (100) moduliert ist und dass den Empfangselementen ein Synchrondemodulator (11) zur Erkennung des modulierten vom Objekt (2) reflektierten Licht nachgeschaltet ist.

7. Schaltung nach einem der vorhergehenden Ansprüche, **dadurch gekennzeichnet, dass** eine Vorrichtung zur Erkennung des Antippens der Anzeigeeinheit vorgesehen ist, die einen Timer (28) wirksam schaltet, der die Betätigung der Anzeigeeinheit freigibt.

8. Schaltung nach Anspruch 7, **dadurch gekennzeichnet, dass** die Leuchtdioden (1a,...,1n) und die Empfangselemente wenigstens zwei Reflexionsstrecken ausbilden und dass zur Erkennung des Antippens die daraus anstehenden Einzelsignale (12,13) einer Additionsstufe (18) zur Bildung eines Abstandssignals (S21) von der Anzeigeeinheit zugeführt werden.

9. Schaltung nach Anspruch 7 oder 8, **dadurch gekennzeichnet, dass** die Vorrichtung zur Erkennung eines ein- oder mehrmaligen Antippens ein Bewegungsmuster als Antippen erkennt, das die Annäherung des Objekts, das abrupte Abbremsen des Objekts an einer angetippten Fläche sowie ein Verweilen auf der Fläche für eine vorgegebene Zeit (t28) umfasst.

10. Schaltung nach einem der vorhergehenden Ansprüche, **dadurch gekennzeichnet, dass** die Leuchtdioden (1a,...,1n) und die Empfangselemente wenigstens zwei Reflexionsstrecken ausbilden und dass ein Komparator (14) die daraus anstehenden Einzelsignale (12,13) zur Entscheidung über die Bewegungsrichtung zur Erzeugung eines digitalen Ausgangssignals (S15) vergleicht und dass vorzugsweise ein weiterer Vergleicher (16) die daraus anstehenden Einzelsignale (12,13) zur Entscheidung über den Umschaltzeitpunkt zwischen zwei benachbarten Leuchtdioden unter Bildung eines analogen Ausgangssignals (S17) für die Position des Objekts vergleicht.

11. Schaltung nach einem der vorhergehenden Ansprüche, **dadurch gekennzeichnet, dass** eine Simulationsschaltung bei einer randständigen Leuchtdiode (1a) ein Lichtsignal auf der von der randständigen Leuchtdiode (1a) benachbarten Leuchtdiode (1b) abgewandten Seite simuliert, wobei vorzugsweise ein Spannungsteiler (R₁/R₂) vorgesehen ist, dessen Teilerverhältnis so bemessen ist, dass das heruntergeteilte Sendetaktsignal (S100) des Taktgenerators (100) auf der simulierten Seite wenigstens geringfügig größer ist als das durch parasitäre Reflexion an der translucenten Oberfläche entstandene Empfangssignal der benachbarten Leuchtdiode (1b).

12. Schaltung nach einem der vorhergehenden Ansprüche, **dadurch gekennzeichnet, dass** die Steuereinrichtung (24) aufgrund der Ausgangssignale die Leuchtdioden so steuert, dass sich die das Anzeigeelement bildende Leuchtdiode (1c) unter dem Objekt befindet.

13. Schaltung nach Anspruch 12, **dadurch gekennzeichnet, dass** die Steuereinrichtung (24), wenn das Objekt unverändert zwischen benachbarten Leuchtdioden stehen bleibt, zwischen benachbarten Leuchtdioden hin- und herschaltet, und die Empfindlichkeit für die Positionserfassung erhöht, bis ein vorgegebener Wert überschritten ist, wobei bei mehrmaligem Hin- und Herschalten vorzugsweise ein Entscheidungshilfsmittel vorzugsweise in Form eines Hysteresedetektors (84) aktiviert wird, das solange das Empfangselement immer unempfindlicher schaltet, bis die dem Objekt näher liegende Leuchtdiode auswählbar ist, und das dann wieder in den für die Erfassung einer weiteren Bewegung des Objekts empfindlichen Zustand übergeht.

14. Schaltung nach einem der Ansprüche 12 bis 13, **dadurch gekennzeichnet, dass** das Ausgangssignal (S17) im Zeitpunkt des Umschaltens auf einen bestimmten vorgegebenen oder vorgebbaren Wert referiert wird, so dass nach dem Umschalten mit einem Teil des Ausgangssignals (S17) der nächste Schwellwert (US;OS) erreicht wird.

15. Schaltung nach einem der vorhergehenden Ansprüche, **dadurch gekennzeichnet, dass** das Ausgangssignal (S17) für die Position des Objekts ignoriert wird, wenn sich zugleich das Abstandssignal (S21) unter Entfernung des Objekts von der Anzeigeeinheit ändert, und dass, wenn sich das Ausgangssignal (S17) für die Position des Objekts beim Entfernen um mehr als einen vorgegebenen Wert ändert, die Steuereinrichtung (24) vorzugsweise die Leuchtdiode auswählt, an der das Objekt zuletzt länger als eine vorgegebene Verweilzeit (t28) verweilt hat.

16. Schaltung nach einem der vorhergehenden Ansprüche, **dadurch gekennzeichnet, dass** mehrere Reihen von Leuchtdioden (1a,...,1n) zur Verlängerung des Arbeitsweges kaskadiert sind und/oder dass die letzte Leuchtdiode (1n) einer Reihe funktionell mit der ersten Leuchtdiode (1a) derselben Reihe unter Bildung eines virtuellen Drehknopfs verbunden ist und/oder dass die Leuchtdioden (1a,...,1n) bogen- oder kreisförmig angeordnet sind.

17. Schaltung nach einem der vorhergehenden Ansprüche, **dadurch gekennzeichnet, dass** die Steuereinrichtung (24) alle Leuchtdioden (1a,..,1c) bis zur Position des Objekts bzw. bis zur Position des Empfangselements als Anzeigeelemente zur Bildung eines Leuchtbands schaltet.

## Claims

1. Circuit with an optoelectronic display unit for the discrete display of the setting of a control/adjusting unit (30) with
• at least one detection element for detection of the actuation of the control/adjusting unit (30) by means of an object such as e.g. a finger (2) for changing the setting of the contxol/adjusting unit, wherein upon actuation the detection element delivers an output signal (S23) corresponding to the desired change,
• a plurality of light-emitting diodes (1a, ..., 1n) emitting light radiation, which are configured as display elements of the display unit,
• a control means (24), which in dependency on the output signal generated by the detection element actuates at least one of the light-emitting diodes (1a, ..., 1n) to display the respective setting and also the control/adjusting unit (30) to change the setting,
**characterised in that** the control means (24) actuates at least one of the light-emitting diodes, the detection elements and also the control/adjusting unit (30) on the basis of the output signal (S23), which is formed in dependence on the movement of the object in relation to the light-emitting diode (1c) emitting light radiation, following the movement of the object, and that either at least two receiving elements responsive to the light radiation of the light-emitting diodes (1a, ..., 1n) are provided, which as detection elements detect the light radiation emitted by at least one light-emitting diode (1c) and reflected by the object (2), or that at least one receiving element responsive to the light radiation of the light-emitting diodes (1a, ..., 1n) is provided, which as detection element detects the light radiation emitted by at least two light-emitting diodes (1c) and reflected by an object (2), wherein in both cases the control means (24) advances the receiving element or elements (1b, 1d) arranged next to the light-emitting diode (1c) emitting light radiation to the next receiving element and the light-emitting diode to the next light-emitting diode in the same direction, as soon as the control means (24) advances the display unit on the basis of the output signal (S23).

2. Circuit according to claim 1, **characterised in that** the direction of movement is along the row of light-emitting diodes (1a, ..., 1n),

3. Circuit according to claim 1 or 2, **characterised in that** the receiving element is one of the light-emitting diodes (1b, 1d), which is actuated at least intermittent so that it generates a voltage upon illumination.

4. Circuit according to one of the preceding claims, **characterised in that** the light-emitting diodes (1a, ..., 1n) are operated as transmitter and receiving element in a time-sequential manner.

5. Circuit according to one of the preceding claims, **characterised in that** those light-emitting diodes (1b, 1d) directly adjacent to the light-emitting diode (1c) emitting light radiation are operated as receiving element, and that as soon as the control means (24) advances the display unit to the next light-emitting diode on the basis of the output signal (S23), the adjacent light-emitting diodes operated as receiving element also advance in the same direction.

6. Circuit according to one of the preceding claims, **characterised in that** the light radiation emitted by the light-emitting diode (1c) is modulated by a clock generator (100), and that a synchronous demodulator (11) is connected downstream of the receiving elements to identity the modulated light reflected by the object (2).

7. Circuit according to one of the preceding claims, **characterised in that** a device for identifying tapping of the display unit is provided, which activates timer (28), which enables actuation of the display unit.

8. Circuit according to claim 7, **characterised in that** the light-emitting diodes (1a, ..., 1n) and the receiving elements form at least two reflection paths, and that to identify the tapping action the individual signals (12, 13) present on the receiving elements are fed to an addition stage (18) to form a spacing signal (S21) from the display unit.

9. Circuit according to claim 7 or 8, **characterised in that** the device for identifying a single or multiple tapping action identifies a movement pattern as tapping action, which comprises approach of the object, abrupt slowing down of the object at a tapped surface and also staying on the surface for a predetermined time (t28).

10. Circuit according to one of the preceding claims, **characterised in that** the light-emitting diodes (1a, ..., 1n) and the receiving elements form at least two reflection paths, and that a comparator (14) compares the individual signals (12, 13) arising therefrom to decide on the direction of movement for generation of a digital output signal (S15), an that preferably a further comparator (16) compares the individual signals (12, 13) present on the receiving elements to decide on the switchover time point between two adjacent light-emitting diodes with the formation of an analogue output signal (S17) for the position of the object.

11. Circuit according to one of the preceding claims, **characterised in that** a simulation circuit at an edge light-emitting diode (1a) simulates a light signal on the side remote from the light-emitting diode (1b) adjacent to the edge light-emitting diode (1a), wherein a voltage divider (R₁/R₂) is preferably provided, the dividing ratio is dimensioned such that the divided transmission clock signal (S100) of the clock generator (100) is at least slightly greater on the simulated side than the reception signal of the adjacent light-emitting diode (1b) resulting from parasitic reflection at the translucent surface.

12. Circuit according to one of the preceding claims, **characterised in that** the control means (24) controls the light-emitting diodes on the basis of the output signals such that the light-emitting diode (1c) forming the display element is located under the object.

13. Circuit according to claim 12, **characterised in that** if the object stops unchanged between adjacent light-emitting diodes, the control means (24) switches back and forth between adjacent light-emitting diodes and the sensitivity for position detection increases until a predetermined value is exceeded, wherein on switching back and forth several times a decision aid preferably in the form of a hysteresis detector (84) is preferably activated, which switches the receiving element to be increasingly insensitive until the light-emitting diode located closer to the object can be selected, and which then again moves into the sensitive state for detection of a further movement of the object.

14. Circuit according to one of claims 12 to 13, **characterised in that** at the time of the switchover the output signal (S17) is referenced to a specific predetermined or predeterminable value so that after the switchover the next threshold (US;OS) is reached with a part of the output signal (S17).

15. Circuit according to one of the preceding claims, **characterised in that** the output signal (S 17) for the position of the object is ignored if the spacing signal (S21) changes at the same time with removal of the object from the display unit, and that if on removal the output signal (S17) for the position of the object changes by more than a predetermined value, the control device (24) preferably selects the light-emitting diode, at which the object last stayed longer than a predetermined dwell time (t28).

16. Circuit according to one of the preceding claims, **characterised in that** a plurality of rows of light-emitting diodes (1a, ..., 1n) arc arranged in cascade to extend the working path and/or that the last light-emitting diode (1n) of a row is functionally connected to the first light-emitting diode (1a) of the same row with the formation of a virtual rotary knob and/or that the light-emitting diodes (1a, ..., 1n) are arranged in the shape of an arc or a circle.

17. Circuit according to one of the preceding claims, **characterised in that** the control device (24) switches all the light-emitting diodes (1a, ...,1c) as far as the position of the object or the position of the receiving element as display elements to form a light strip.

## Revendications

1. Circuit pourvu d'une unité d'affichage optoélectronique, pour l'affichage discret du réglage d'une unité de réglage/ajustement (30) comportant
- au moins un élément de capture pour la capture de l'actionnement de l'unité de réglage/ajustement (30) au moyen d'un objet, comme par exemple un doigt (2), pour la modification du réglage de l'unité de réglage/ajustement, l'élément de capture fournissant, lors de son actionnement, un signal de sortie (S23) correspondant à la modification souhaitée,
- plusieurs diodes électroluminescentes (1a, ..., 1n) émettant un rayonnement lumineux et qui se présentent sous la forme d'éléments d'affichage de l'unité d'affichage,
- un dispositif de commande (24), qui commande, en fonction du signal produit par l'élément de capture, au moins une des diodes électroluminescentes (1a, ..., 1n) pour l'affichage du réglage correspondait ainsi que l'unité de réglage/ajustement, pour la modification du réglage,
**caractérisé en ce que** le dispositif de commande (24) commande, en suivant le déplacement de l'objet, au moins une des diodes électroluminescentes, les éléments de capture que l'unité de réglage/ajustement (30) sur la base du signal de sortie (S23) qui est formé en fonction du déplacement de l'objet par rapport à la diode électroluminescente (1c) émettant le rayonnement lumineux, et **en ce que** soit il est prévu au moins deux éléments de réception sensibles au rayonnement lumineux des diodes électroluminescentes (1a, ..., 1n) et qui, en tant qu'éléments de capture, capturent le rayonnement lumineux émis par au moins une diode électroluminescente (1c) et réfléchi par l'objet (2), soit il est prévu au moins un élément de réception sensible au rayonnement lumineux des diodes électroluminescentes (1a,..., 1n) et qui, en tant qu'élément de capture, capture le rayonnement lumineux émis par au moins deux diodes électroluminescentes (1c) et réfléchi par un objet (2), avec ceci que dans les deux cas, le dispositif de commande (24) commute de l'élément ou des éléments de réception (1b, 1d), qui est(sont) disposé(s) à côté de la diode électroluminescente (1c) émettant le rayonnement lumineux, à l'élément de réception suivant et de la diode électroluminescente à la diode électroluminescente suivant dans la même direction, dès que le dispositif de commande (24) commande l'unité d'affichage sur la base du signal de sortie (S23).

2. Circuit selon la revendication 1, **caractérisé en ce que** la direction du déplacement correspond à la rangée de diodes électroluminescentes (1a,..., 1n).

3. Circuit selon la revendication 1 ou 2, **caractérisé en ce que** l'élément de réception est l'une des diodes électroluminescentes (1b, 1d) qui est pilotée au moins temporairement, de sorte qu'elle une tension lors de son allumage.

4. Circuit selon l'une des revendications précédentes, **caractérisé en ce que** les diodes électroluminescentes (1a,..., 1n) sont actionnées de façon séquencée en tant qu'émettrices et éléments de réception.

5. Circuit selon l'une des revendications précédentes, **caractérisé en ce que** les diodes électroluminescentes (1b, 1d) qui sont directement adjacentes à la diode électroluminescente (1c) émettant le rayonnement lumineux sont actionnées comme éléments de réception et **en ce que**, dès que le dispositif de conmande (24) commute de l'unité d'affichage sur la base du signal de sortie (S23) à la diode électroluminescente suivante, les diodes électroluminescentes adjacentes actionnées comme éléments de réception commutent également dans la même direction.

6. Circuit selon l'une des revendications précédentes, **caractérisé en ce que** le rayonnement lumineux émis par la diode électroluminescente (1c) est modulé par un générateur de cadence (100) et **en ce qu'**un démodulateur synchrone est connecté aux éléments de réception pour reconnaître la lumière modulée réfléchie par l'objet (2).

7. Circuit selon l'une des revendications précédentes, **caractérisé en ce qu'**il est prévu un dispositif pour reconnaître l'effleurement de l'unité d'affichage qui enclenche une minuterie (28) qui libère l'actionnement de l'unité d'affichage.

8. Circuit selon la revendication 7, **caractérisé en ce que** les diodes électroluminescentes (1a,..., 1n) et les éléments de réception forment au moins deux trajets de réflexion et **en ce que**, pour la reconnaissance de l'effleurement, les signaux individuels (12, 13) ainsi différés sont fournis à une étape d'addition (18) pour la formation d'un signal d'éloignement (S21) de l'unité d'affichage.

9. Circuit selon la revendication 7 ou 8, **caractérisé en ce que** le dispositif pour la reconnaissante d'un ou plusieurs effleurements reconnaît un modèle de déplacement en tant qu'effleurement, lequel comprend le rapprochement de l'objet, le freinage brusque de l'objet sur une surface effleurée ainsi que l'arrêt sur la surface pendant une durée prédéterminé (t28).

10. Circuit selon l'une des revendications précédentes, **caractérisé en ce que** les diodes électroluminescentes (1a,..., 1n) et les éléments de déception forment au moins deux trajets de réflexion et **en ce qu'**un comparateur (14) compare les signaux individuels (12, 13) ainsi différés pour une décision sur la direction de déplacement pour produire un signal de sortie numérique (S25) et **en ce qu'**un autre comparateur (16) compare les signaux individuels (12, 13) ainsi différés pour une décision sur le moment de commutation entre deux diodes électroluminescentes voisines, en formant un signal de sortie analogique (S17) pour la position de l'objet.

11. Circuit selon l'une des revendications précédentes, **caractérisé en ce qu'**un circuit de simulation simule, sur une diode électroluminescence située en bordure (1a), un signal lumineux du côté opposé à la diode électroluminescente (1b) voisine de la diode électroluminescente située en bordure (1a), un diviseur de tension (R1/R2) étant de préférence prévu, dont le rapport de division est mesuré de telle sorte que le signal de cadence divisé (S100) du générateur de cadence (100) soit supérieur au moins de façon insignifiante, du côté simulé, au signal de réception de la diode électroluminescente voisine (1b) produit par la réflexion parasitaire au niveau de la surface translucide.

12. Circuit selon l'une des revendications précédentes, **caractérisé en ce que** le dispositif de commande (24) commande les diodes électroluminescentes sur la base des signaux de sortie de telle sorte que la diode électroluminescente (1c) formant l'élément d'affichage se trouve sous l'objet.

13. Circuit selon la revendication 12, **caractérisé en ce que** le dispositif de commande (24), lorsque l'objet reste immobile entre des diodes électroluminescentes voisines, commute alternativement entre deux diodes luminescentes voisines et augmente la sensibilité pour la capture de position, jusqu'à ce qu'une valeur prédéterminé soit dépassée, un moyen d'aide à la décision de préférence sous la forme d'un détecteur d'hystérésis (84) étant de préférence activé en cas de pluralité de commutations alternative, ce détecteur rendant l'élément de capture de façon de plus en plus insensible, jusqu'à ce que la diode électroluminescente la plus proche de l'objet soit sélectionnable, et revenant ensuite de nouveau à l'état sensible à la capture d'un autre déplacement de l'objet.

14. Circuit selon l'une des revendications 12 et 13, **caractérisé en ce que** le signal de sortie (S17) est de nouveau référencé, au moment de la commutation, à une certaine valeur prédéterminée ou fixée préalablement, de sorte qu'après la commutation la valeur suivante programmée (US,OS) soit atteinte avec une partie du signal de sortie (S17).

15. Circuit selon l'une des revendications précédentes, **caractérisé en ce que** le signal de sortie (S1) pour la position de l'objet est ignoré lorsque le signal d'éloignement (S21) varie en même temps en raison de l'éloignement de l'objet de l'unité d'affichage et **en ce que**, lorsque le signal de sortie (S17) pour la positon de l'objet varie lors de l'éloignement de plus d'une valeur prédéterminée, le dispositif de commande (24) sélectionne de préférence la diode électroluminescente sur laquelle l'objet s'est arrêté en dernier plus longtemps qu'une durée d'arrêt prédéterminée (t28).

16. Circuit selon l'une des revendications précédentes, **caractérisé en ce que** plusieurs rangées de diodes électroluminescentes (1a,... 1n) sont montées en cascade pour prolonger le chemin de travail et/ou **en ce que** la dernière diode électroluminescente (1n) d'une rangée est reliée fonctionnellement à la première diode électroluminescente (1a) de la même rangée en formant un bouton tournant virtuel et/ou **en ce que** les diodes électroluminescentes (1a,..., 1n) sont disposées en arc de cercle ou en forme de cercle.

17. Circuit selon l'une des revendications précédentes, **caractérisé en ce que** le dispositif de commande (24) commande toutes les diodes électroluminescentes (1a,..., 1c) jusqu'à la position de l'objet ou jusqu'à la position de l'élément de réception en tant qu'élément d'affichage pour former une bande lumineuse.
